# EUROPÄISCHE PATENTSCHRIFT

(11) **EP 0 978 159 B1**
(45) Veröffentlichungstag und Bekanntmachung des Hinweises auf die Patenterteilung: **24.10.2001**
(21) Anmeldenummer: 98931894.4
(22) Anmeldetag: 09.04.1998
(51) Int. Cl.: H02H 9/00, H01L 29/86

(54) **VORRICHTUNG ZUM BEGRENZEN ELEKTRISCHER WECHSELSTRÖME, INSBESONDERE IM KURZSCHLUSSFALL**
DEVICE FOR LIMITING ELECTRICAL ALTERNATING CURRENTS, ESPECIALLY DURING SHORT-CIRCUITS
DISPOSITIF POUR LIMITER DES COURANTS ELECTRIQUES ALTERNATIFS, NOTAMMENT EN CAS DE COURT-CIRCUIT

(30) Priorität: 25.04.1997 DE 19717614; 24.06.1997 DE 19726678; 05.02.1998 DE 29801945 U
(43) Veröffentlichungstag der Anmeldung: 09.02.2000
(73) Patentinhaber: SiCED Electronics Development GmbH & Co KG, 91052 Erlangen (DE)
(72) Erfinder: MITLEHNER, Heinz, D-91080 Uttenreuth (DE); STEPHANI, Dietrich, D-91088 Bubenreuth (DE); BARTSCH, Wolfgang, D-91054 Erlangen (DE)
(74) Vertreter: Zedlitz, Peter, Dipl.-Inf.
(86) Internationale Anmeldenummer: DE9801029
(87) Internationale Veröffentlichungsnummer: WO9849762

(56) Entgegenhaltungen:
- WO-A-95/01667
- WO-A-95/07571
- WO-A-97/23911
- DE-U- 9 411 601

## Beschreibung

Die Erfindung betrifft eine Vorrichtung zum Begrenzen elektrischer Wechselströme.

Zum Versorgen eines elektrischen Verbrauchers (Gerätes) mit einem elektrischen Wechselstrom wird der Verbraucher über ein Schaltgerät mit einem Leitungsabzweig eines elektrisches Versorgungsnetzes verbunden. Zum Schutz des Verbrauchers vor zu hohen Strömen, insbesondere im Kurzschlußfall, werden in der Niederspannungsschalttechnik Schaltgeräte mit den Abzweig schützenden Trennern, für die im allgemeinen Schmelzsicherungen verwendet werden, und mit mechanischen Leistungsschaltern mit Schaltzeiten von deutlich mehr als einer Millisekunde (1 ms) eingesetzt. Werden in einem Leitungsabzweig mehrere Verbraucher gleichzeitig betrieben und tritt bei nur einem dieser Verbraucher ein Kurzschluß auf, so ist es von großem Vorteil, wenn die nicht mit dem Kurzschluß behafteten Verbraucher ungestört weiterarbeiten können und nur der vom Kurzschluß betroffene Verbraucher abgeschaltet wird. Zu diesem Zweck sind unmittelbar vor jeden Verbraucher geschaltete strombegrenzende Bauelemente ("Limiter") notwendig, die innerhalb einer Zeit von deutlich weniger als 1 ms und somit vor dem Auslösen des für den Leitungsabzweig vorgesehenen Trenners (des Leitungsschutzschalters) den Strom von dem prospektiven Kurzschlußstrom sicher auf einen vorgegebenen, nicht kritischen Überstromwert begrenzen.

Solche Stromlimiter müssen die im Strombegrenzungsfall am Bauelement anstehenden hohen Spannungen von üblicherweise bis zu 700 V und bisweilen bis zu 1200 V abhängig vom Netz aushalten können. Da die dann im Bauelement entstehende Verlustleistung sehr hoch ist, wäre es besonders vorteilhaft, wenn der Strombegrenzer zusätzlich den Strom auf Werte deutlich unterhalb des vorgegebenen Überstromwertes unter zusätzlicher Aufnahme von Spannung selbsttätig reduzieren würde (eigensicheres Bauelement).

Der einzige am Markt erhältliche passive Strombegrenzer ist das in dem Aufsatz *"Polyäthylen-Stromwächter für den Kurzschlußschutz" von T. Hansson, ABB Technik 4/92, Seiten 35-38* beschriebene Gerät mit dem Produktnamen PROLIM, das auf einer stromabhängigen Leitfähigkeit der Korngrenzen des in diesem Gerät eingesetzten Materials beruht. Jedoch kann bei häufigerem Gebrauch des Geräts zur Strombegrenzung eine Änderung des Stromsättigungswertes, bei dem der Strom begrenzt wird, auftreten.

Ansonsten werden im allgemeinen nur aktive, d.h. mit Ansteuerung arbeitende, Strombegrenzer eingesetzt, die den Strom erfassen und bei Überschreiten eines vorgegebenen Maximalstromwertes durch aktives Steuern begrenzen. Aus *DE-A-43 30 459* ist ein solcher aktiver Strombegrenzer auf Halbleiterbasis bekannt. Dieser aktive strombegrenzende Halbleiterschaler weist ein erstes Halbleitergebiet eines vorgegebenen Leitungstyps auf, dem an voneinander abgewandten Oberflächen jeweils eine Elektrode zugeordnet sind. In dem ersten Halbleitergebiet sind nun zwischen den beiden Elektroden weitere Halbleitergebiete vom entgegengesetzten Leitungstyp voneinander beabstandet angeordnet. Zwischen den einzelnen weiteren Halbleitergebieten sind jeweils Kanalgebiete des ersten Halbleitergebietes gebildet, die senkrecht zu den beiden Oberflächen des ersten Halbleitergebietes gerichtet sind (vertikale Kanäle). Ein vertikaler Stromfluß zwischen den beiden Elektroden wird durch diese Kanalgebiete geführt und dadurch begrenzt. Zur Steuerung des Stromflusses zwischen den beiden Elektroden wird an die entgegengesetzt dotierten Halbleitergebiete in dem ersten Halbleitergebiet eine Gatespannung angelegt werden, durch die der Widerstand der Kanalgebiete gesteuert werden kann.

Aus der *DE-A-195 48 443* ist eine Halbleiteranordnung bekannt mit einem ersten Halbleitergebiet eines vorgegebenen Leitungstyps, einem an einer Oberfläche des ersten Halbleitergebiets angeordneten Kontaktgebiet und einem innerhalb des ersten Halbleitergebietes unterhalb des Kontaktgebietes angeordneten zweiten Halbleitergebiet vom entgegengesetzten Leitungstyp wie das erste Halbleitergebiet. Das zweite Halbleitergebiet ist in allen Richtungen parallel zur Oberfläche des ersten Halbleitergebiets weiter ausgedehnt als das Kontaktgebiet, so daß in dem ersten Halbleitergebiet wenigstens ein Kanalgebiet gebildet ist, das nach unten durch die Verarmungszone des zwischen dem ersten Halbleitergebiet und dem zweiten Halbleitergebiet gebildeten p-n-Übergangs begrenzt ist und in einem Durchlaßzustand einen elektrischen Strom vom Kontaktgebiet oder zum Kontaktgebiet trägt. Das wenigstens eine Kanalgebiet ist somit lateral in dem ersten Halbleitergebiet angeordnet und weist dadurch ein sehr gutes Sättigungsverhalten auf. An einer von der genannten Oberfläche des ersten Halbleitergebiets abgewandten, weiteren Oberfläche des ersten Halbleitergebiets ist ein weiteres Kontaktgebiet angeordnet. Zwischen diesem Kontaktgebiet und dem Kontaktgebiet an der anderen Oberfläche des ersten Halbleitergebiets kann dann eine Betriebsspannung für die Halbleiteranordnung angelegt werden.

Das Kanalgebiet wird in der aus *DE-A-195 48 443* bekannten Halbleiteranordnung in einer Weiterbildung auf einer dem zweiten Halbleitergebiet gegenüberliegenden Seite von einer Verarmungszone eines weiteren p-n-Übergangs begrenzt, der mit dem ersten Halbleitergebiet und wenigstens einem dritten Halbleitergebiet vom entgegengesetzten Leitungstyp wie das erste Halbleitergebiet gebildet ist. Dem dritten Halbleitergebiet ist eine Steuerelektrode zugeordnet zum Steuern des elektrischen Widerstands des Kanalgebiets durch Anlegen einer Steuerspannung. In einer anderen Weiterbildung wird das Kanalgebiet auf einer dem zweiten Halbleitergebiet gegenüberliegenden Seite von der Verarmungszone wenigstens eines Schottky-Kontakts begrenzt. Auch in dieser Ausführungsform ist an dem Schottky-Kontakt eine Steuerspannung anlegbar zum Steuern des elektrischen Widerstands des Kanalgebiets.

WO-A-95/07571 offenbart (vgl. die Zusammenfassung, Fig. 1 und Fig. 3) einen Wechselstromsteller, der zumindest mit zwei antiseriellen Halbleiterbereichen (1; 2) arbeitet. Jeder Halbleiterbereich (1; 2) hat Elektronenspender (3; Source), Elektronensammler (4; Drain) und den Elektronenfluß steuernde Elektrode (5; Gate) bei Kennlinien, wie sie FETs aufweisen. Technologiegebunden weist der Halbleiterbereich auch innere Bodydioden auf. Es ist vorgesehen, daß jeweils am Halbleiterbereich (1; 2) in Durchlaßrichtung die Gate-Source-Spannung (6; 7) so groß eingestellt ist, daß sich die gewünschte Begrenzung das Drain-Source-Stroms einstellt. Am Halbleiterbereich im Inversbetrieb (2; 1) ist die Gate-Source-Spannung (7; 6) so groß eingestellt, daß die Bodydiode (8) noch stromlos ist. Diese Schrift offenbart also eine Vorrichtung zum Begrenzen elektrischer Wechselströme, von der sich der Gegenstand nach Anspruch 1 dadurch unterscheidet, daß die Schaltung auf eine passive Halbleiteranordnung eingeschränkt ist. Die Halbleiteranordnung nach Anspruch 1 unterscheidet sich darüber hinaus durch ihre Kennlinie, die bei zunehmender Vorwärtsspannung gekennzeichnet ist durch ein Ansteigen des Stroms bis zu dem Sättigungsstrom und danach durch ein Absinken auf einen unterhalb des Sättigungsstroms liegenden Begrenzungsstrom.

WO-A-95/01667 offenbart (vgl. die Zusammenfassung und Fig. 1) eine Vorrichtung zum Schutz von Schaltungen gegenüber Überlastung oder Transienten. Die Vorrichtung beinhaltet einen Schaltungsteil, der aus einem p-Kanal-FET (7) und einem n-Kanal-FET (6) besteht, deren Kanäle in Serie geschaltet sind und wobei der Gate-Anschluß jedes der Transistoren mit dem Drain-Anschluß des jeweils anderen Transistors verbunden ist. Der Gegenstand des Anspruches 1 unterscheidet sich von diesem Stand der Technik durch die passive Ausbildung und die Kennlinie.

Der Erfindung liegt nun die Aufgabe zugrunde, eine Vorrichtung zum Begrenzen elektrischer Wechselströme anzugeben, die auch bei schnell wiederkehrenden Wechselspannungen im Kurzschlußfall robust und zuverlässig die entsprechenden Wechselströme begrenzen kann.

Diese Aufgabe wird gemäß der Erfindung gelöst mit den Merkmalen des Anspruchs 1.

Gemäß der Erfindung wird in den Strompfad des zu begrenzenden Wechselstromes wenigstens eine Halbleiteranordnung geschaltet, die so ausgebildet oder steuerbar ist, daß sie bei Anliegen einer Vorwärtsspannung mit einer vorgegebenen Polarität (Vorwärtsrichtung, Durchlaßrichtung) von einem Vorwärtsstrom durchflossen wird, der mit ab Spannung Null steigender Vorwärtsspannung bis auf einen Sättigungsstrom bei einer zugehörigen Sättigungsspannung monoton, vorzugsweise im wesentlichen linear (ohmsche Kennlinie), zunimmt und bei einer oberhalb der Sättigungsspannung liegenden Vorwärtsspannung auf einen Begrenzungsstrom unterhalb des Sättigungsstromes, vorzugsweise unterhalb etwa eines Fünftels des Sättigungsstromes, begrenzt wird. Jedoch kann diese Halbleiteranordnung bei umgekehrter Polarität (Rückwärtsrichtung) den Strom nicht begrenzen (keine symmetrische Kennlinie). Vielmehr fließt bei Anliegen einer Rückwärtsspannung durch die Halbleiteranordnung ein Rückwärtsstrom, der mit ab Spannung Null steigender Rückwärtsspannung bis zu einer vorgegebenen Rückwärtsdurchbruchsspannung monoton zunimmt und bei Überschreiten der Rückwärtsdurchbruchsspannung durch einen Ladungsträgerdurchbruch schnell ansteigt. Bei einem Ladungsträgerdurchbruch kann die Halbleiteranordnung jedoch leicht zerstört werden.

Deshalb ist gemäß der Erfindung weiter eine Schutzschaltung für die Halbleiteranordnung oder die Halbleiteranordnungen vorgesehen, die jede Halbleiteranordnung vor dem Erreichen oder gar Überschreiten der Rückwärtsdurchbruchsspannung in der in Rückwärtsrichtung gepolten Halbwelle des Wechselstromes schützt, insbesondere in einem Überstrom- oder Kurzschlußfall, bei dem hohe Ströme auftreten. Es wird also die in einer Halbwelle des Wechselstromes ohne Schutzschaltung normalerweise an der Halbleiteranordnung anliegende Rückwärtsspannung mit Hilfe der Schutzschaltung reduziert, oder ein Betrieb der Halbleiteranordnung in deren Rückwärtsrichtung wird praktisch ganz vermieden.

Mit dieser vorteilhafte Kombination von Maßnahmen wird erstmalig ein ausschließlich mit Halbleiterbauelementen aufgebauter Wechselstrombegrenzer angegeben, der ebenso robust, weitgehend unabhängig von der nachgeschalteten (anhängenden) Last und zuverlässig wie mit mechanischen Schaltern ausgestattete Wechselstrombegrenzer einen Wechselstrom im Überstrom- oder Kurzschlußfall auf einen akzeptablen Stromwert, den Begrenzungsstrom, limitiert.

Vorteilhafte Ausgestaltungen und Weiterbildungen der Vorrichtung gemäß der Erfindung ergeben sich aus den vom Anspruch 1 abhängigen Ansprüchen.

In drei grundsätzlichen Ausführungsformen wird die Schutzschaltung jeweils mit Hilfe von Dioden, insbesondere (bipolaren) p-n-Dioden oder (unipolaren) Schottky-Dioden, realisiert, für die kostengünstige Standard-Leistungsdioden auf Siliciumbasis verwendet werden können.

In der ersten dieser drei grundsätzlichen Ausführungsformen ist die Schutzschaltung mit zwei Antiparallelschaltungen aus jeweils einer Halbleiteranordnung und einer Diode verwirklicht, welche Antiparallelschaltungen zueinander antiseriell in den Stromweg des Wechselstromes geschaltet sind.

Die Dioden werden nun in ihren Eigenschaften so auf die Halbleiteranordnungen abgestimmt, daß der Wechselstrom im Nennbetrieb zumindest überwiegend und vorzugsweise praktisch vollständig durch die beiden antiseriell geschalteten Halbleiteranordnungen fließt und in einem Überstromfall oder Kurzschlußfall in jeder Halbwelle des Wechselstromes bis auf den Sättigungsstrom bei der Sättigungsspannung der in dieser Halbwelle in Vorwärtsrichtung gepolten Halbleiteranordnung monoton, vorzugsweise im wesentlichen linear (ohmsche Kennlinie) zunimmt und bei einer oberhalb der Sättigungsspannung liegenden Vorwärtsspannung von dieser Halbleiteranordnung auf den Begrenzungsstrom unterhalb des Sättigungsstromes begrenzt wird sowie praktisch ausschließlich durch die in Vorwärtsrichtung liegende Halbleiteranordnung und zumindest überwiegend durch die zweite Diode fließt.

In jeder Antiparallelschaltung ist vorzugsweise die maximale Sperrspannung (Durchbruchsspannung) der zugehörigen Diode mindestens so groß wie die maximale Vorwärtsspannung beim Begrenzungsstrom und vorzugsweise wie die Vorwärtsdurchbruchsspannung der zugehörigen Halbleiteranordnung. Damit wird sichergestellt, daß die Diode im Vorwärtsbetrieb der zugehörigen Halbleiteranordnung, sei es im Nennstrombetrieb oder im Überstrombetrieb, nicht früher durchbricht als die Halbleiteranordnung, also mindestens genauso gut wie die Halbleiteranordnung sperrt. Ferner ist die Durchlaßschwellspannung (Schleusenspannung, Barrierenspannung) jeder Diode betragsmäßig kleiner als die Rückwärtsdurchbruchsspannung der zugehörigen, antiparallel geschalteten Halbleiteranordnung zudem kleiner als die Sättigungsspannung der zu der jeweils anderen Diode antiparallel geschalteten Halbleiteranordnung. Vorzugsweise ist auch die Durchlaßspannung jeder Diode beim Sättigungsstrom der in der jeweils anderen Antiparallelschaltung befindlichen Halbleiteranordnung kleiner als die Sättigungsspannung dieser Halbleiteranordnung, um einen möglichst großen Anteil des Stromes im Überlast- oder Kurzschlußfall durch die Diode zu bringen.

Der Stromfluß durch diese erste grundsätzliche Ausführungsform der strombegrenzende Vorrichtung ist also im Nennbetrieb einerseits und im kritischen Überstrom- oder gar Kurzschlußbetrieb andererseits verschieden. Der Wechselstrombegrenzer "erkennt" also als "intelligenter Limiter" auch ohne Steuerung (passive Ausführung) und insbesondere ohne Messung des Stromes die Stromstärke und schaltet den Strom entsprechend, um eine optimale Wirkung zu erzielen. Im Nennbetrieb werden die Dioden nur wenig oder gar nicht vom Strom durchflossen, so daß die Durchlaßverluste minimiert werden. Im Überstrom- oder Kurzschlußfall wird dagegen die in Rückwärtsrichtug liegende Halbleiteranordnung vor dem Stromfluß und einem dadurch verursachten Ansteigen seiner Rückwärtsspannung geschützt und die antiparallel liegende Diode übernimmt (trägt) den begrenzten Strom der in Vorwärtsrichtung liegenden Halbleiteranordnung.

Die zweite grundsätzliche Ausführungsform des Wechselsstrombegrenzers sieht ebenfalls zwei Halbleiteranordnungen und zwei Dioden vor. Jedoch sind nun jeweils eine Diode und eine Halbleiteranordnung seriell geschaltet und die beiden resultierenden Serienschaltungen sind antiparallel geschaltet. Die maximale Sperrspannung (Rückwärtsdurchbruchsspannung) jeder Diode ist betragsmäßig mindestens so groß wie die maximale Rückwärtsspannung (Rückwärtsdurchbruchsspannung) der zugehörigen, in Reihe geschalteten Halbleiteranordnung. Damit wird sichergestellt, daß die Diode im Rückwärtsbetrieb der zugehörigen Halbleiteranordnung im Überstrom- oder Kurzschlußbetrieb nicht früher durchbricht als die Halbleiteranordnung, also mindestens genauso gut wie die Halbleiteranordnung sperrt, und die Rückwärtsspannung der Halbleiteranordnung übernehmen kann.

Ein gewisser Nachteil der genannten ersten und der zweiten Ausführungsform besteht darin, daß eine Halbleiteranordnung mit den beschriebenen Eigenschaften im allgemeinen deutlich teurer sein wird als eine einfache Diode, so daß durch die zwei Halbleiteranordnungen vergleichsweise hohe Gesamtkosten hingenommen werden müssen.

Eine kostengünstigere Variante des Wechselstrombegrenzers ist die dritte grundsätzliche Ausführungsform, die mit nur einer einzigen Halbleiteranordnung auskommt, die in eine Graetz-Brücke aus vier Dioden als Schutzschaltung für diese Halbleiteranordnung geschaltet ist. Die Beschaltung ist nun derart, daß der Wechselstrom bei jeder der beiden Polaritäten die Halbleiteranordnung in deren Vorwärtsrichtung durchfließt, wobei vor und nach der Halbleiteranordnung jeweils eine in Durchlaßrichtung geschaltete Diode im Stromweg liegt.

Die maximale Sperrspannung jeder Diode ist im allgemeinen vorzugsweise mindestens so groß wie die maximale Vorwärtsspannung beim Begrenzungsstrom und vorzugsweise wie die Vorwärtsdurchbruchsspannung der Halbleiteranordnung.

In einer vorteilhaften Weiterbildung jeder der bislang beschriebenen Ausführungsformen der Vorrichtung besteht jede Halbleiteranordnung wenigstens teilweise aus einem Halbleitermaterial, das einen Bandabstand von wenigstens 2 eV aufweist. Diese Halbleiter weisen eine im Vergleich zu dem "Universalhalbleiter" Silicium deutlich höhere Durchbruchsfestigkeit auf, so daß der Wechselstrombegrenzer für höhere Wechselspannungen eingesetzt werden kann. Das bevorzugte Halbleitermaterial für jede Halbleiteranordnung ist Siliciumcarbid (SiC), insbesondere einkristallines Siliciumcarbid vom 3C- oder 4H- oder 6H-Polytyp, weil SiC überragende elektronische und thermische Eigenschaften aufweist.

Die Halbleiteranordnung oder Halbleiteranordnungen können jeweils oder gemeinsam mit einer oder mehreren Dioden auf einem Halbleitersubstrat, das insbesondere aus Silicium oder Siliciumcarbid besteht, integriert sein, können aber auch als diskrete Bauelemente miteinander verdrahtet werden.

Die wenigstens eine Halbleiteranordnung der wechselstrombegrenzenden Vorrichtung kann nun in einer vorteilhaften Weiterbildung eine erste, als ohmscher Kontakt vorzugsweise auf wenigstens einem an einer ersten Oberfläche des ersten Halbleitergebietes angeordneten Kontaktgebiet angeordnete Elektrode und eine an der ersten Oberfläche oder vorzugsweise an einer von der ersten Oberfläche abgewandten zweiten Oberfläche des ersten Halbleitergebietes angeordnete zweite Elektrode und ein elektrisch zwischen der ersten Elektrode und der zweiten Elektrode liegendes oder erzeugbares Kanalgebiet in einem ersten Halbleitergebiet aufweisen, das bei Erreichen des Sättigungsstromes von wenigstens einer Verarmungszone (Zone mit Verarmung an Ladungsträger und damit hohem elektrischem Widerstand) abgeschnürt (überdeckt) wird.

Die das Kanalgebiet begrenzende oder abschnürende wenigstens eine Verarmungszone ist vorzugsweise von einem p-n-Übergang zwischen dem ersten Halbleitergebiet und einem zweiten Halbleitergebiet, das innerhalb des ersten Halbleitergebietes unterhalb des Kontaktgebiets angeordnet ist und sich in allen Richtungen parallel zur ersten Oberfläche des ersten Halbleitergebiets weiter erstreckt als das Kontaktgebiet, gebildet. Diese Ausführungsform der Halbleiteranordnung ist wegen des lateralen Kanals besonders durchbruchsfest und wegen der Ladungsspeicherung im vergrabenen zweiten Halbleitergebiet und der daraus resultierenden auch bei abnehmender Spannung an den beiden Elektroden gegen Ende der Halbwellen anhaltenden Abschnürung des Kanalgebietes imstande, den Begrenzungsstrom (Sperrstrom) als akzeptablen Stromwert über eine vorgegebene Begrenzungszeit (Sperrzeit) im wesentlichen beizubehalten.

Wenn nun mehrere Kontaktgebiete an der ersten Oberfläche des ersten Halbleitergebietes vorgesehen sind, so kann nun unterhalb jedes Kontaktgebietes ein zugehöriges zweites Halbleitergebiet angeordnet sein oder unterhalb aller Kontaktgebiete ein zusammenhängendes zweites Halbleitergebiet angeordnet sein, das in allen Richtungen parallel zur ersten Oberfläche des ersten Halbleitergebietes weiter ausgedehnt ist als die kleinste, alle Kontaktgebiete umfassende Fläche. Durch Zwischenräume zwischen den disjunkten zweiten Halbleitergebieten oder durch Öffnungen in dem zusammenhängenden zweiten Halbleitergebiet verlaufen dann jeweils Kanalgebiete des ersten Halbleitergebietes, die elektrisch in Reihe zu jeweils wenigstens einem der den Kontaktgebieten zugeordneten Kanalgebieten liegen.

Das Kanalgebiet ist in einer weiteren Ausführungsform an wenigstens einer Seite von wenigstens einer Verarmungszone eines Schottky-Kontakts begrenzt oder abgeschnürt. Der Schottky-Kontakt kann insbesondere mit der ersten Elektrode und einem außerhalb des wenigstens einen Kontaktgebietes liegenden Bereich des ersten Halbleitergebietes gebildet sein. Dies kann beispielsweise durch geeignet gewählte Dotierungen dieser beiden Gebiete erreicht werden. Es kann der Schottky-Kontakt aber auch mit einer zusätzlichen Steuerelektrode, an die eine Steuerspannung anlegbar ist, und einem außerhalb des wenigstens einen Kontaktgebietes liegenden Bereich des ersten Halbleitergebietes gebildet sein.

In einer besonders vorteilhaften Ausführungsform ist wenigstens eine der Verarmungszone am Kanalgebiet mit der Verarmungszone eines zusätzlichen p-n-Übergangs gebildet, der zwischen dem ersten Halbleitergebiet und einem dritten Halbleitergebiet, das an der ersten Oberfläche des ersten Halbleitergebietes angeordnet ist.

In einer ersten Weiterbildung dieser Ausführungsform mit wenigstens einem drittem Halbleitergebiet wird das dritte Halbleitergebiet mit einer Steuerelektrode kontaktiert. Durch Anlegen einer Steuerspannung an diese Steuerelektrode kann die Ausdehnung der Verarmungszone des p-n-Übergangs gesteuert werden und damit der elektrische Widerstand des Kanalgebietes. In dieser Weiterbildung kann das Kanalgebiet auch normalerweise abgeschnürt und erst durch Anlegen der Steuerspannung geöffnet (erzeugt) werden. Mit dieser steuerbaren Halbleiteranordnung kann ein aktiver Wechselstrombegrenzer realisiert werden.

Eine zweite Weiterbildung zeichnet sich dadurch aus, daß ein Ladungsspeichereffekt auch zusätzlich in dem dritten Halbleitergebiet ausgenutzt wird. Dies wird erreicht durch elektrisches Isolieren des dritten Halbleitergebietes an seiner Oberfläche mit einem Isolator.

Es kann aber auch in einer dritten Weiterbildung die erste Elektrode außer dem wenigstens einen Kontaktgebiet des ersten Halbleitergebiet auch das dritte Halbleitergebiet an seiner nicht an das erste Halbleitergebiet angrenzenden Oberfläche kontaktieren und damit Kontaktgebiet und drittes Halbleitergebiet elektrisch kurzschließen.

In einer vierten Weiterbildung wird die erste Elektrode zusätzlich an jedes zweite Halbleitergebiet derart, im allgemeinen über eine elektrische Impedanz, elektrisch angekoppelt, daß eine vorgegebene Relaxationszeit für die gespeicherten Ladungen im zweiten Halbleitergebiet eingestellt ist.

Bei allen Ausführungsformen, bei denen ein Ladungsspeicherungseffekt ausgenutzt wird, sind die Halbleitermaterialien mit hohem Bandabstand von wenigstens 2 eV besonders geeignet wegen ihrer extrem niedrigen intrinsischen Ladungsträgerkonzentration (Ladungsträgerkonzentration ohne Dotierung), die eine Ladungsspeicherung begünstigt oder erst ermöglicht.

Zur weiteren Erläuterung der Erfindung wird auf die Zeichnung Bezug genommen, in deren
- FIG 1: ein Wechselstrombegrenzer gemäß der Erfindung mit zwei antiseriell geschalteten Halbleiteranordnungen und mit zwei jeweils antiparallel geschalteten Schutzdioden,
- FIG 2: ein Wechselstrombegrenzer mit einer in eine Graetz-Gleichrichterschaltung aus vier Schutzdioden geschalteten Halbleiteranordnung,
- FIG 3: ein Wechselstrombegrenzer mit zwei antiparallel geschalteten Reihenschaltungen aus jeweils einer Halbleiteranordnung und einer Schutzdiode,
- FIG 4: eine Halbleiteranordnung mit einem lateralen Kanalgebiet, das von einem p-n-Übergang nach unten und einem Schottky-Kontakt nach oben begrenzt wird,
- FIG 5: eine Halbleiteranordnung mit einem lateralen Kanalgebiet, das von zwei p-n-Übergängen oben bzw. unten begrenzt wird,
- FIG 6: eine Ausführungsform einer Halbleiteranordnung mit lateralen und vertikalen Kanalgebieten und mit einer Steuerelektrode,
- FIG 7: eine Ausführungsform einer Halbleiteranordnung mit lateralen und vertikalen Kanalgebieten und mit einem Isolatorgebiet an der Oberfläche,
- FIG 8: eine Halbleiteranordnung mit einem Zelldesign in einer Draufsicht,
- FIG 9: eine Halbleiteranordnung mit am Rand elektrisch kontaktierten vergrabenen Halbleitergebieten und
- FIG 10: eine Schalteinrichtung mit Wechselstromlimiter für einen Verbraucher
jeweils schematisch dargestellt sind. Einander entsprechende Teile sind in den FIG 1 bis 10 mit denselben Bezugszeichen versehen.

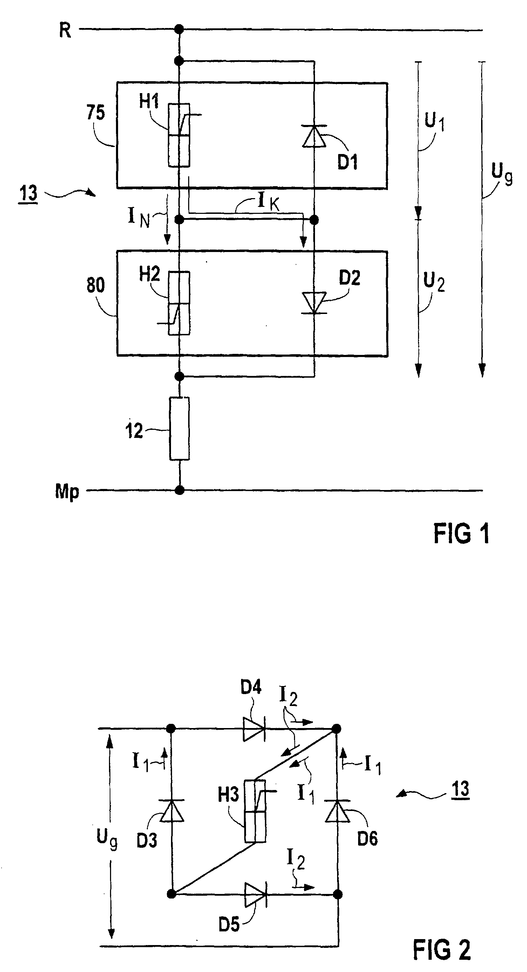

FIG 1 zeigt eine Vorrichtung 13 zum Begrenzen von Wechselströmen, die zum Schutz eines elektrischen Verbrauchers 12 bei einem elektrischen Kurzschluß oder hohen Überströmen vor den Verbraucher 12 in Reihe geschaltet ist. Die stromlimitierende Vorrichtung 13 und der Verbraucher 12 liegen in einem Leitungsabzweig für den elektrischen Verbraucher 12 zwischen einer Wechselspannungsphase R und Massepotential (Nullpotential) Mp. Die über der gesamten Strombegrenzervorrichtung 13 abfallende elektrische Betriebswechselspannung ist mit U_{g} bezeichnet. Die Strombegrenzervorrichtung 13 umfaßt eine erste Antiparallelschaltung 75 aus einer ersten Halbleiteranordnung H1 und einer ersten Diode D1 sowie eine zweite Antiparallelschaltung 80 aus einer zweiten Halbleiteranordnung H2 und einer zweiten Diode D2. Die beiden unipolaren und vorzugsweise im wesentlichen baugleichen Halbleiteranordnungen H1 und H2 und die beiden Dioden D1 und D2 weisen jeweils eine Vorwärtsrichtung (Durchlaßrichtung) und eine Rückwärtsrichtung (Sperrichtung) auf. Die antiparallele Schaltung bedeutet, daß die Halbleiteranordnung H1 oder H2 und die zugehörige Diode D1 bzw. D2 parallel zueinander liegen und die damit an Halbleiteranordnung H1 bzw. H2 und zugehöriger Diode D1 bzw. D2 anliegende elektrische Spannung U₁ bzw. U₂ für die Halbleiteranordnung H1 bzw. H2 in Vorwärtsrichtung oder Rückwärtsrichtung und für die zugehörige Diode D1 bzw. D2 entsprechend gerade umgekehrt in Rückwärtsrichtung bzw. Vorwärtsrichtung gepolt (gerichtet) ist. Die beiden Antiparallelschaltungen 75 und 80 sind nun antiseriell zueinander geschaltet, so daß für die an ihnen als Spannungsmaschen abfallenden Spannungen U₁ + U₂ = U_{g} gilt. Im einzelnen sind dadurch zwischen die Wechselspannungsphase R und den Verbraucher 12 sowohl die beiden Halbleiteranordnungen H1 und H2 antiseriell zueinander als auch die beiden Dioden D1 und D2 antiseriell zueinander geschaltet. An diesen beiden Antireihenschaltungen der beiden Halbleiteranordnungen H1 und H2 bzw. Dioden D1 und D2 fällt jeweils die Betriebsspannung U_{g} der Strombegrenzungsvorrichtung 13 ab.

In FIG 2 ist eine andere Vorrichtung 13 zum Begrenzen elektrischer Wechselströme mit einer Graetz-Brückenschaltung von vier Dioden D3, D4, D5 und D6 dargestellt. In eine Diagonale der Graetz-Schaltung ist eine Halbleiteranordnung H3 geschaltet. Die über der Halbleiteranordnung H3 anstehende Spannung ist mit U₃ bezeichnet. An die andere Diagonale wird eine Betriebsspannung (Wechselspannung) U_{g} der Strombegrenzervorrichtung angelegt.

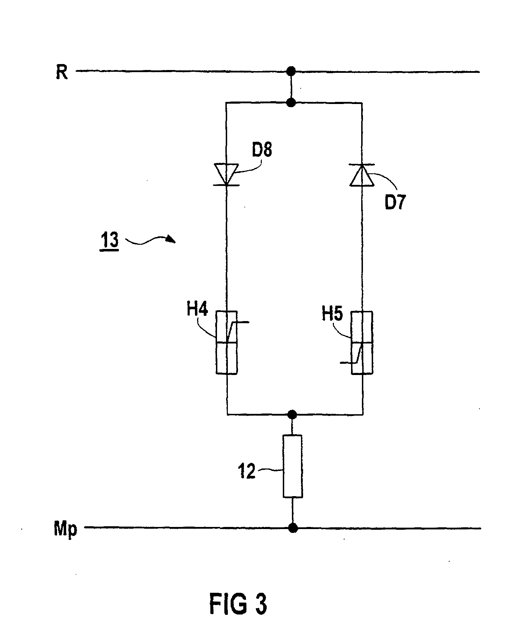

Die weitere Vorrichtung 13 zum Begrenzen elektrischer Wechselströme gemäß FIG 3 weist zwei vorzugsweise identisch aufgebaute Halbleiteranordnungen H4 und H5 auf. Jede Halbleiteranordnung H4 und H5 ist mit jeweils einer Diode D8 bzw. D4 in Reihe geschaltet mit gleicher Polarität. Die beiden Serienschaltungen aus jeweils einer Halbleiteranordnung H4 bzw. H5 und einer Diode D8 bzw. D7 sind zueinander antiparallel, d.h. mit entgegengesetzten Polaritäten, verschaltet. Diese Antiparallelschaltung ist nun mit dem Verbraucher (der Last) 12 zwischen die Phase R und das Massepotential Mp in den Strompfad des im Störfall zu begrenzenden Wechselstromes geschaltet.

Die beiden Halbleiteranordnungen H1 und H2 gemäß FIG 1, die Halbleiteranordnung H3 gemäß FIG 2 und die beiden Halbleiteranordnungen H4 und H5 gemäß FIG 3 weisen nun jeweils folgende Eigenschaften auf:

Bei Anliegen einer Vorwärtsspannung, beispielsweise + U₁ bzw. + U₂, wird jede Halbleiteranordnung H1, H2, H3, H4 oder H5 jeweils von einem Vorwärtsstrom +I durchflossen, der in einem Vorwärtsnennstrombereich von I = 0 A bei Spannung 0 V (U₁ = 0 V bzw. U₂ = 0 V) vorzugsweise im wesentlichen linear, d.h. gemäß einem ohmschem Verhalten, mit steigender Vorwärtsspannung (U₁ bzw. U₂) bis auf einen maximalen Nennstrom anwächst und in einem oberhalb des maximalen Nennstromes liegenden Überstrombereich monoton und vorzugsweise ebenfalls im wesentlichen ohmsch mit der Vorwärtsspannung (U₁ bzw. U₂) bis auf einen Sättigungsstrom Iₛₐₜ bei einer zugehörigen Sättigungsspannung Uₛₐₜ zunimmt. Falls nun der Vorwärtsstrom, wie im Falle eines Kurzschlusses in dem Verbraucher 12, weiter wachsen will, die Vorwärtsspannung (U₁ bzw. U₂) über der zugehörigen Halbleiteranordnung (H1 und H2) also weiter über die Sättigungsspannung Uₛₐₜ hinaus ansteigt, so begrenzt jede Halbleiteranordnung (H1 bzw. H2) den Vorwärtsstrom nach Erreichen des Sättigungsstromes Iₛₐₜ auf einen Begrenzungsstrom I_{B}, der deutlich, vorzugsweise um wenigstens das fünffache, unterhalb des Sättigungsstromes Iₛₐₜ liegt. Dabei vermag jede Halbleiteranordnung H1 bis H5 den Begrenzungsstrom in einem Vorwärtsspannungsbereich oberhalb der Sättigungsspannung bis zu einer jeweiligen Vorwärtsdurchbruchsspannung zu halten. Bei der Vorwärtsdurchbruchsspannung geschieht ein Ladungsträgerdurchbruch, aufgrund dessen der Strom wieder rasch ansteigt und bei anhaltender Spannung schnell zur Zerstörung der Halbleiteranordnung H1 bis H5 führen würde.

Bei Anlegen einer entgegengesetzt zur Vorwärtsspannung gepolten Rückwärtsspannung (- U₁ bzw. - U₂) wird jede Halbleiteranordnung (H1 und H2) dagegen von einem Rückwärtsstrom -I durchflossen, der der in einem Rückwärtsnennstrombereich von I = 0 A bei Spannung 0 V (U₁ = 0 V bzw. U₂ = 0 V) wieder vorzugsweise im wesentlichen linear, d.h. gemäß einem ohmschem Verhalten, mit betragsmäßig steigender (absolut bei den gewählten Vorzeichen fallender) Rückwärtsspannung (-U₁ bzw. - U₂) bis auf einen maximalen Rückwärtsnennstrom anwächst und in einem betragsmäßig oberhalb des maximalen Nennstromes liegenden Überstrombereich monoton, vorzugsweise ebenfalls im wesentlichen ohmsch, mit betragsmäßig weiter steigender Rückwärtsspannung zunimmt bis zu einer vorgegebenen Rückwärtsdurchbruchsspannung, bei der ein Ladungsdurchbruch geschieht und die Halbleiteranordnung H1 bzw. H2 bzw. H3 bzw. H4 bzw. H5 kein kontrolliertes Verhalten mehr zeigt.

Die Eigenschaften der insbesondere als p-n-Gleichrichterdioden oder auch Schottky-Dioden ausgebildeten Dioden D1 bis D8 in den Vorrichtungen 13 gemäß den FIG 1 bis 3 werden in folgender Weise auf die Eigenschaften der zugehörigen Halbleiteranordnungen H1 bis H5 abgestimmt:

In der Variante gemäß FIG 1 sind in jeder Antiparallelschaltung 75 und 80 die Rückwärtsdurchbruchsspannung der zugehörigen Diode D1 bzw. D2 mindestens so groß wie die Durchlaßdurchbruchsspannung der zugehörigen Halbleiteranordnung H1 bzw. H2 und die Durchlaßspannung (in Vorwärtsrichtung der Diode) der Diode D1 bzw. D2 beim Sättigungsstrom Iₛₐₜ der Halbleiteranordnung H2 bzw. H1 der jeweils anderen Antiparallelschaltung 80 bzw. 75 kleiner als die Sättigungsspannung dieser Halbleiteranordnung H2 bzw. H1. Die Schwellenspannung jeder Diode D1 und D2 ist kleiner als die Rückwärtsdurchbruchsspannung der zugehörigen Halbleiteranordnung H1 bzw. H2, damit ein ausreichender Strom durch die Diode D1 bzw. D2 fließt, bevor die Halbleiteranordnung H1 bzw. H2 "durchbricht". Dadurch fließt der elektrische Strom zwischen R und MP im Nennstrombereich (als Nennstrom I_{N} bezeichnet) im wesentlichen über die Serienschaltung der beiden Halbleiteranordnungen H1 und H2 und nicht über die wegen ihrer Schwellspannung mit einem deutlich höheren Durchlaßwiderstand als die Halbleiteranordnungen H1 und H2 behafteten Dioden D1 und D2. Somit tragen die Dioden D1 und D2 im Nennbetrieb praktisch nicht zur Verlustleistung der Vorrichtung 13 bei. Im Überlast- oder Kurzschlußfall dagegen übernimmt abhängig von der Polarität der Wechselspannung jeweils die in Durchlaßrichtung geschaltete Diode D1 oder D2 den Begrenzungsstrom (als limitierter Kurzschlußstrom I_{K} bezeichnet) der in den Sperrzustand in Vorwärtsrichtung getriebenen Halbleiteranordnung H2 bzw. H1 der jeweils anderen Antiparallelschaltung 80 bzw. 75. Der limitierte Strom I_{K} fließt nun jeweils über eine Halbleiteranordnung H1 bzw. H2 und eine Diode D2 bzw. D1. Dadurch wird die parallel zur stromführenden Diode D2 oder D1 liegende Halbleiteranordnung H2 bzw. H1 nicht durch den limitierten Strom I_{K} der anderen Halbleiteranordnung H1 bzw. H2 in hohe Spannungen getrieben und ein "Durchbrennen" dieser Halbleiteranordnung H2 bzw. H1 durch Ladungsträgerdurchbruch wird vermieden. Die dargestellte Wechselstrombegrenzerschaltung gemäß FIG 1 erkennt auch bei passiven Halbleiteranordnungen H1 und H2 ohne Steuerung selbsttätig als "intelligenter Limiter" einen Überlast- oder Kurzschlußfall, ohne daß eine Strommessung erforderlich wäre.

In der Ausführungsform der Wechselstrombegrenzungsvorrichtung 13 gemäß FIG 2 sind die vier Dioden D3 bis D6 in der Gleichrichter-Brückenschaltung (Graetz-Brücke) derart gewählt, daß die maximale Sperrspannung jeder Diode D3 bis D6 vorzugsweise mindestens so groß wie die maximale Vorwärtsspannung der Halbleiteranordnung H3 bei ihrem Begrenzungsstrom und vorzugsweise mindest so groß und vorzugsweise größer als die Vorwärtsdurchbruchsspannung der Halbleiteranordnung H3 ist. Ferner ist jede Diode D3 bis D6 so ausgebildet, daß sie in ihrer Durchlaßrichtung den Begrenzungsstrom der Halbleiteranordnung H3 tragen kann. Bei Anlegen der Betriebswechselspannung U_{g} fließt nun der Wechselstrom in einer Halbwelle als mit I₁ bezeichnete Strom erst durch die Diode D6 in deren Durchlaßrichtung, dann durch die Halbleiteranordnung H3 in deren Vorwärtsrichtung und anschließend durch die Diode D3 in deren Durchlaßrichtung und in der anderen Halbwelle als mit I₂ bezeichneter Strom erst durch die Diode D4, dann durch die Halbleiteranordnung H3 in deren Vorwärtsrichtung und anschließend durch die Diode D5. Die Beschaltung ist somit derart, daß der Wechselstrom bei jeder der beiden Polaritäten die Halbleiteranordnung H3 in deren Vorwärtsrichtung durchfließt und die Halbleiteranordnung H3 deshalb nie in ihre Rückwärtsspannung getrieben wird. Diese Ausführungsform gemäß FIG 2 ist im allgemeinen kostengünstiger als die Ausführungsform gemäß FIG 1, hat jedoch gegenüber dieser den Nachteil, daß immer die Durchlaßwiderstände zweier Dioden im Stromweg liegen und dadurch die Durchlaßverluste im Nennstrombetrieb erhöht werden.

In der Vorrichtung 13 gemäß FIG 3 ist die maximale Sperrspannung (Rückwärtsdurchbruchsspannung) jeder Diode D7 und D8 betragsmäßig mindestens so groß wie die maximale Rückwärtsspannung (Rückwärtsdurchbruchsspannung) der zugehörigen, in Reihe geschalteten Halbleiteranordnung H5 bzw. H4. Damit wird sichergestellt, daß die Diode D7 bzw., D8 im Rückwärtsbetrieb der zugehörigen Halbleiteranordnung H5 bzw. H4 im Überstrom- oder Kurzschlußbetrieb nicht früher durchbricht als die Halbleiteranordnung H5 bzw. H4, also mindestens genauso gut wie die Halbleiteranordnung H5 bzw. H4 sperrt, und die Rückwärtsspannung der Halbleiteranordnung H5 bzw. H4 zumindest weitgehend übernehmen kann. Auch durch diese Schutzschaltung werden die Halbleiteranordnungen H4 und H5 in ihren Rückwärtsrichtungen geschützt. Jedoch hat dieser Wechselstrombegrenzer gemäß FIG 3 den Nachteil, daß die Kosten für zwei Halbleiteranordnungen H4 und H5 aufgebracht werden müssen und in jeder Polarität der Wechselspannung eine Diode im Stromweg liegt und damit zur Verlustleistung beiträgt.

Als stromlimitierende Halbleiteranordnung H1 bis H5 mit den für die Ausführungsbeispiele gemäß den FIG 1 bis 3 beschriebenen Eigenschaften kann beispielsweise jeweils eine aus der eingangs genannten *DE-A-195 48 443* bekannte Halbleiteranordnung verwendet werden, die einem JFET mit lateralem Kanal entspricht. Die Polarität der Halbleiteranordnung ist durch die Wahl der Leitungstypen der Halbleitergebiete anzupassen. An die Steuerelektrode der Halbleiteranordnung wird in einer passiven Ausführung eine feste (konstante) Steuerspannung (genauer: Steuerpotential) und in einer aktiven Ausführungsform eine variable Steuerspannung angelegt.

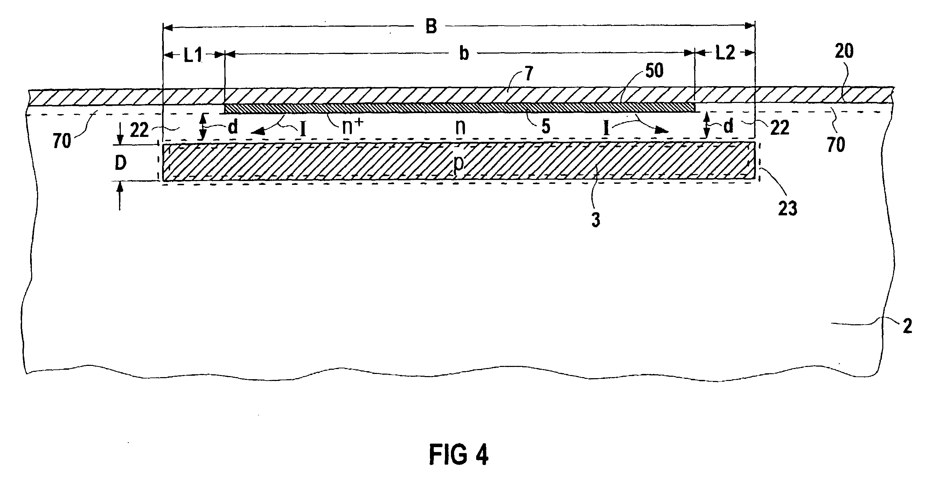

Weitere Ausführungsbeispiele für Halbleiteranordnungen H1 bis H5, die die genannten Eigenschaften zeigen, werden anhand der FIG 4 bis 9 näher erläutert.

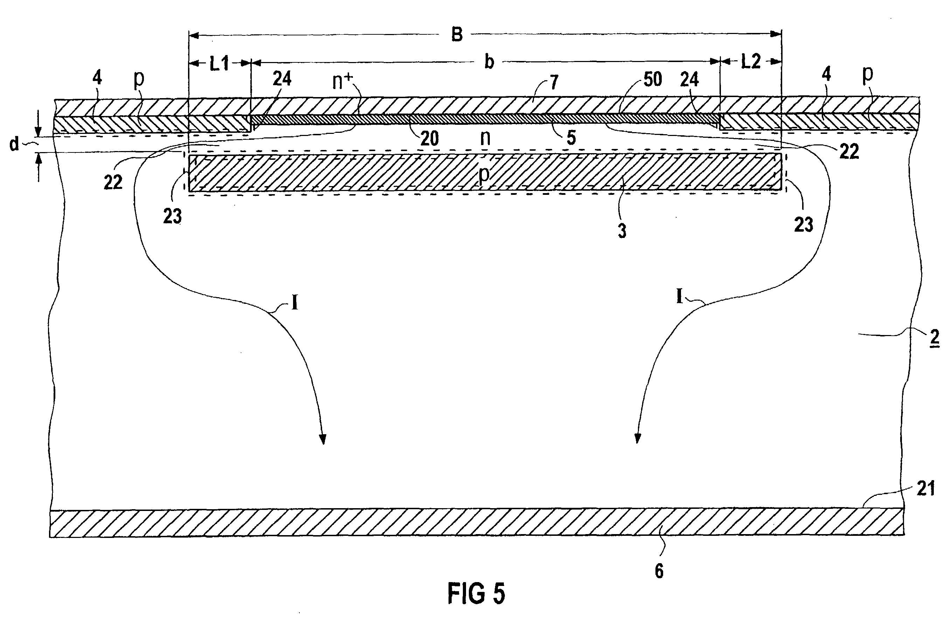

Die in den FIG 4 und 5 dargestellten Halbleiteranordnungen umfassen jeweils ein erstes Halbleitergebiet 2 vom n-Leitungstyp (Elektronenleitung) und ein zweites Halbleitergebiet 3 vom p-Leitungstyp (Löcherleitung). Das erste Halbleitergebiet 2 weist eine vorzugsweise planare (ebene) Oberfläche 20 auf. Das zweite Halbleitergebiet 3 ist unterhalb dieser Oberfläche 20 innerhalb des ersten Halbleitergebiets 2 angeordnet (vergraben) und verläuft wenigstens an seiner der Oberfläche 20 des ersten Halbleitergebiets 2 zugewandten Seite lateral, d.h. im wesentlichen parallel zur Oberfläche 20 des ersten Halbleitergebiets 2. Vorzugsweise wird das zweite Halbleitergebiet 3 durch Ionenimplantation von Dotierstoffteilchen in die Oberfläche 20 des ersten Halbleitergebiets 2 erzeugt. Ein gewünschtes Dotierprofil wird durch das Eindringprofil bei der Ionenimplantation mittels der Ionenenergie unter Berücksichtigung etwaiger Implantationsmasken eingestellt. Insbesondere ergeben sich daraus die Tiefe des implantierten Halbleitergebietes 3, d.h. der Abstand dieses zweiten Halbleitergebietes 3 von der Oberfläche 20 des ersten Halbleitergebietes 2 und die vertikale, d.h. senkrecht zur Oberfläche 20 des ersten Halbleitergebiets 2 gemessene, Ausdehnung D des zweiten Halbleitergebiets 3. Zur Herstellung der Halbleitergebiete 2 und 3 kann aber auch ein epitaktisches Wachstum entsprechender Halbleiterschichten und ein anschließendes Strukturieren dieser Schichten verwendet werden. Die vertikale Ausdehnung D des zweiten Halbleitergebietes 3 beträgt insbesondere zwischen etwa 0,1 µm und etwa 1,0 µm. Die laterale Ausdehnung des zweiten Halbleitergebiets 3 parallel zur Oberfläche 20 des ersten Halbleitergebiets 2 im dargestellten Querschnitt ist mit B bezeichnet und im allgemeinen zwischen etwa 10 µm und etwa 30 µm gewählt. Zwischen dem ersten Halbleitergebiet 2 und dem entgegengesetzt dotierten zweiten Halbleitergebiet 3 ist ein p-n-Übergang gebildet, dessen Verarmungszone (Raumladungszone, Zone mit Verarmung an Ladungsträgern) mit 23 bezeichnet ist und gestrichelt eingezeichnet ist. Die Verarmungszone 23 des p-n-Übergangs umgibt das gesamte zweite Halbleitergebiet 3. Die Ausdehnung einer Verarmungszone eines p-n-Übergangs in das p-Gebiet und das n-Gebiet richtet sich dabei bekanntlich nach der Maßgabe der sich aus den Dotierkonzentrationen ergebenden Ladungsträgerkonzentrationen gemäß dem Poisson-Gesetz und dem Prinzip der Ladungserhaltung sowie der am p-n-Übergang anliegenden Spannung (Potentialdifferenz).

An der Oberfläche 20 des ersten Halbleitergebiets 2 ist gemäß FIG 4 und FIG 5 ein Kontaktgebiet 5 zum ohmschen Kontaktieren vorgesehen. Das ohmsche Kontaktgebiet 5 ist vorzugsweise höher dotiert und vom gleichen Leitungstyp wie das erste Halbleitergebiet 2, im dargestellten Ausführungsbeispiel durch n⁺ angedeutet. Die laterale Ausdehnung des Kontaktgebiets 5 im dargestellten Querschnitt ist mit b bezeichnet und ist in allen Richtungen parallel zur Oberfläche 20 des ersten Halbleitergebiets 2 kleiner als die laterale Ausdehnung B des zweiten Halbleitergebiets 3. Üblicherweise liegt die laterale Ausdehnung b des Kontaktgebietes zwischen etwa 6 µm and etwa 28 µm. Das zweite Halbleitergebiet 3 und das Kontaktgebiet 5 sind relativ zueinander so angeordnet, daß in einer Projektion senkrecht zur Oberfläche 20 des ersten Halbleitergebiets 2 die Projektion des Kontaktgebiets 5 vollständig innerhalb der Projektion des zweiten Halbleitergebiets 3 liegt. Auf der freien Oberfläche 50 des Kontaktgebiets 5 ist eine erste Elektrode 7 aus einem elektrisch leitenden Material angeordnet, insbesondere aus Polysilicium oder einem Metall, vorzugsweise Nickel (Ni), Tantal (Ta), Titan (Ti) oder Wolfram (W). Die erste Elektrode 7 erstreckt sich auch über die angrenzende Halbleiteroberfläche.

In der Ausführungsform gemäß FIG 4 bildet die erste Elektrode 7 nun auf dem Kontaktgebiet 5 einen ohmschen Kontakt und auf der Oberfläche 20 des ersten Halbleitergebietes 2 einen Schottky-Kontakt, dessen Verarmungszone (Sperrschicht) mit 70 bezeichnet ist und gestrichelt eingezeichnet ist. Dies kann beispielsweise durch eine geeignete Einstellung der Ladungsträgerkonzentrationen des Kontaktgebietes 5 und des ersten Halbleitergebietes 2 beim Dotieren erreicht werden. Wenn das erste Halbleitergebiet 2 und das Kontaktgebiet 5 jeweils aus dem besonders vorteilhaften Halbleitermaterial Siliciumcarbid (SiC) bestehen, wählt man insbesondere die Dotierstoffkonzentration des Kontaktgebietes 5 über etwa 1·10¹⁹ cm⁻³ und des ersten Halbleitergebietes 2 kleiner als etwa 2·10¹⁶ cm⁻³. Ein vorteilhaftes Material für die erste Elektrode 7 ist dann Nickel (Ni).

In der Ausführungsform gemäß FIG 5 ist dagegen an der Oberfläche 20 des ersten Halbleitergebietes 2 ein drittes Halbleitergebiet 4 angeordnet, das vom entgegengesetzten Leitungstyp wie das erste Halbleitergebiet 2 ist, also im dargestellten Ausführungsbeispiel vom p-Leitungstyp, und vorzugsweise ebenfalls durch Ionenimplantation erzeugt ist. Zwischen dem ersten Halbleitergebiet 2 und dem dritten Halbleitergebiet 4 ist ein p-n-Übergang gebildet, dessen Verarmungszone mit 24 bezeichnet ist und gestrichelt eingezeichnet ist. Die erste Elektrode 7 erstreckt sich auch über das dritte Halbleitergebiet 4 und bildet sowohl auf dem Kontaktgebiet 5 als auch auf dem dritten Halbleitergebiet 4 einen ohmschen Kontakt.

Zwischen dem an der ersten Oberfläche 20 des ersten Halbleitergebietes 2 angeordneten, mit der ersten Elektrode 7 gebildeten Schottky-Kontakt gemäß FIG 4 oder dem dritten Halbleitergebiet 4 gemäß FIG 5 einerseits und dem vergrabenen zweiten Halbleitergebiet 3 andererseits ist jeweils ein lateral sich erstreckendes, halbleitendes Kanalgebiet 22 im ersten Halbleitergebiet 2 gebildet. Die lateralen Ausdehnungen L1 und L2 des Kanalgebietes 22 auf unterschiedlichen Seiten des Kontaktgebiets 5 können gleich oder auch unterschiedlich groß sein. Typischerweise betragen die Kanallängen L1 und L2 zwischen etwa 1 µm und etwa 5 µm. Die vertikale, d.h. im wesentlichen senkrecht zur Oberfläche 20 gerichtete, Ausdehnung des Kanalgebietes 22 ist im allgemeinen zwischen etwa 0,1 µm und etwa 1 µm gewählt. Da die in das Kanalgebiet 22 sich erstrekkenden Verarmungszonen 23 und 70 in FIG 4 und 23 und 24 in FIG 5 durch die starke Verarmung an Ladungsträgern einen wesentlich höheren elektrischen Widerstand als das erste Halbleitergebiet 2 aufweisen, ist im wesentlichen nur der Innenbereich des Kanalgebietes 22 stromtragfähig, der nach unten durch die Verarmungszone 23 und nach oben durch die Verarmungszone 70 in FIG 4 bzw. 24 in FIG 5 begrenzt ist. Die vertikale Ausdehnung dieses stromführenden Innenbereichs des Kanalgebiets 22 ist mit d bezeichnet.

In FIG 5 ist das dritte Halbleitergebiet 4 so lateral versetzt zum zweiten Halbleitergebiet 3 angeordnet, daß sich die beiden Halbleitergebiete 3 und 4 entlang der Kanallänge L1 auf einer Seite und der Kanallänge L2 auf der anderen Seite in einer Projektion auf die Oberfläche 20 des ersten Halbleitergebiets 2 überlappen. Das dritte Halbleitergebiet 4 umschließt lateral das Kontaktgebiet 5 und grenzt in der dargestellten Ausführungsform unmittelbar an das Kontaktgebiet 5 an, so daß L1 + b +L2 = B für die lateralen Ausdehnungen L1, L2, b und B gilt. Das Kontaktgebiet 5 kann aber auch von dem dritten Halbleitergebiet 4 lateral beabstandet sein.

Bei beiden Ausführungsformen gemäß FIG 4 und FIG 5 ist nun des weiteren eine nur in FIG 5 dargestellte zweite Elektrode 6 vorgesehen, die derart angeordnet ist, daß das Kanalgebiet 22 im Strompfad zwischen den beiden Elektroden liegt. Diese zweite Elektrode kann beispielsweise an der ersten Oberfläche 20 des ersten Halbleitergebietes 2 angeordnet sein (lateraler Aufbau) oder wie in FIG 5 gezeigt an einer von der ersten Oberfläche 20 des ersten Halbleitergebietes 2 abgewandten weiteren Oberfläche 21 des ersten Halbleitergebietes 2 angeordnet sein (vertikaler Aufbau). Zwischen der zweiten Elektrode 6 und der ersten Elektrode 7 wird eine Betriebsspannung der Halbleiteranordnung angelegt. In den Ausführungsbeispielen gemäß FIG 4 und FIG 5 werden die erste Elektrode 7 mit der Kathode und die zweite Elektrode 6 mit der Anode der Betriebsspannungsquelle verbunden. Bei Vertauschung der Leitungstypen der Halbleitergebiete wird die Polarität der Betriebsspannung entsprechend vertauscht.

Das Verhalten der Halbleiteranordnung bei Anliegen einer Betriebsspannung in Durchlaßrichtung (Vorwärtsrichtung) ist nun abhängig von dem durch die Halbleiteranordnung fließenden elektrischen Strom I zwischen den Elektroden 6 und 7. Dieser elektrische Strom I fließt zwischen den beiden Elektroden 6 und 7 in einer durch Pfeile angedeuteten Stromrichtung zunächst im wesentlichen lateral durch das Kanalgebiet 22 im ersten Halbleitergebiet 2 und dann, im Ausführungsbeispiel gemäß FIG 5 weitgehend vertikal, durch den Volumenbereich des ersten Halbleitergebietes 2. Mit steigender Stromstärke I wächst der Vorwärtsspannungsabfall zwischen den Elektroden 6 und 7, so daß das zweite Halbleitergebiet 3 und der Schottky-Kontakt gemäß FIG 4 bzw. das dritte Halbleitergebiet 4 gemäß FIG 5 negativ gegen die zweite Elektrode 6 vorgespannt werden. Der erhöhte Durchlaßspannungsabfall wirkt als höhere Sperrspannung an dem p-n-Übergang zwischen dem ersten Halbleitergebiet 2 und dem zweiten Halbleitergebiet 3 und an dem Schottky-Kontakt gemäß FIG 4 bzw. dem dritten Halbleitergebiet 4 gemäß FIG 5 und führt damit zu einer Vergrößerung der Verarmungszonen 23 und 70 bzw. 24. Dies hat eine Verminderung des Querschnitts und eine entsprechende Widerstandserhöhung des halbleitenden Bereichs des Kanalgebiets 22 zur Folge. Bei Erreichen eines bestimmten kritischen Stromwertes (Sättigungsstrom) I_{Sat} berühren sich die Verarmungszonen 23 und 70 bzw. 24 und schnüren das Kanalgebiet 22 vollständig ab. Wegen des nun erheblich höheren elektrischen Widerstandes im Kanalgebiet 22 geht der Strom nun in Sättigung und bleibt bei gleichbleibender Spannung zwischen den Elektroden 6 und 7 auf dem Sättigungsstromwert I_{Sat}. Der Sättigungsstrom I_{Sat} der Halbleiteranordnung wird durch die geometrischen Abmessungen des Kanalgebiets 22, insbesondere dessen lateralen Ausdehnungen L1 und L2 und vertikale Ausdehnung d, sowie durch die mit der Dotierung festgelegte Ladungsträgerkonzentration des Kanalgebietes 22 auf einen gewünschten Wert eingestellt.

Falls dagegen, wie beispielsweise im Kurzschlußfall, die Vorwärtsspannung zwischen den Elektroden 6 und 7 weiter steigt, nachdem der Strom I bereits den Sättigungsstromwert I_{Sat} erreicht hat, steigt die elektrische Verlustleistung im Kanalgebiet 22, und das Kanalgebiet 22 erwärmt sich. Mit der steigenden internen Temperatur im Kanalgebiet 22 nimmt nun die Beweglichkeit derjenigen Ladungsträger, die in den das Kanalgebiet 22 überdeckenden Verarmungszonen 23 und 70 bzw. 24 verblieben sind, ab. Die Leitfähigkeit des Kanalgebiets 22 sinkt somit weiter, mit der Folge, daß aufgrund des resultierenden höheren Durchlaßspannungsabfalls zwischen den Elektroden 6 und 7 die beweglichen Ladungsträger aus den Verarmungszonen 23 und 70 bzw. 24 im Kanalgebiet 22 verstärkt ausgeräumt werden. Aufgrund dieses Rückkopplungseffektes begrenzt die Halbleiteranordnung auch einen stark anwachsenden elektrischen Strom wie im Kurzschlußfall schnell auf einen unkritischen Stromwert (Begrenzungsstrom) I_{B}, der deutlich unter dem Sättigungsstrom Iₛₐₜ, beispielsweise um höchstens einen Faktor 0,2 (Iₛₐₜ ≥ 5 I_{B}), liegt und bei Erreichen hoher Vorwärtsspannungen im wesentlichen dem Sperrstrom der Halbleiteranordnung für eine gewünschte Vorwärtsdurchbruchsspannung, die typischerweise zwischen etwa 60 V und etwa 1200 V (z.B. auch 700 V) liegen kann, entspricht.

In der Raumladungszone 23 um das vergrabene zweite Halbleitergebiet 3 bleibt die akkumulierte Raumladung abhängig von der intrinsischen Ladungsträgerkonzentration des Halbleiters gespeichert. Durch diese Ladungsspeicherung bleibt das elektrische Potential im zweiten Halbleitergebiet 3 auch bei wieder abnehmender Spannung zwischen den beiden Elektroden 6 und 7 weitgehend erhalten, und das Kanalgebiet 22 bleibt geschlossen. Somit wird mit der Halbleiteranordnung eine schnelle und sichere Begrenzung des Stromes I auf den Sperrstrom I_{B} erreicht. Der Ladungsspeicherungseffekt ist besonders groß, wenn als Halbleitermaterial für die Halbleitergebiete 2, 3 und 4 der Halbleiteranordnung ein Halbleiter mit einem Bandabstand von wenigstens 2 eV, beispielsweise Diamant, Galliumnitrid (GaN) oder Indiumphosphid (InP) und vorzugsweise Siliciumcarbid (SiC), verwendet wird, da solche Halbleiter und insbesondere SiC eine extrem niedrige intrinsische Ladungsträgerkonzentration und sehr geringe Durchlaßverluste aufweisen. Ein weiterer Vorteil von solchen Halbleitern und insbesondere SiC ist deren hohe Durchbruchsfestigkeit. Bevorzugte Polytypen des SiC sind der 4H-, der 6H- und der 3C-Polytyp. Bevorzugte Dotierstoffe für SiC sind Bor und Aluminium für p-Dotierung und Stickstoff für n-Dotierung.

Die Dotierungen des ersten Halbleitergebietes 2, des zweiten Halbleitergebietes 3 und des dritten Halbleitergebietes 4 bestimmen die Sperrfähigkeit der Halbleiteranordnung, wenn zwischen den beiden Elektroden 6 und 7 eine Spannung in Sperrichtung anliegt.

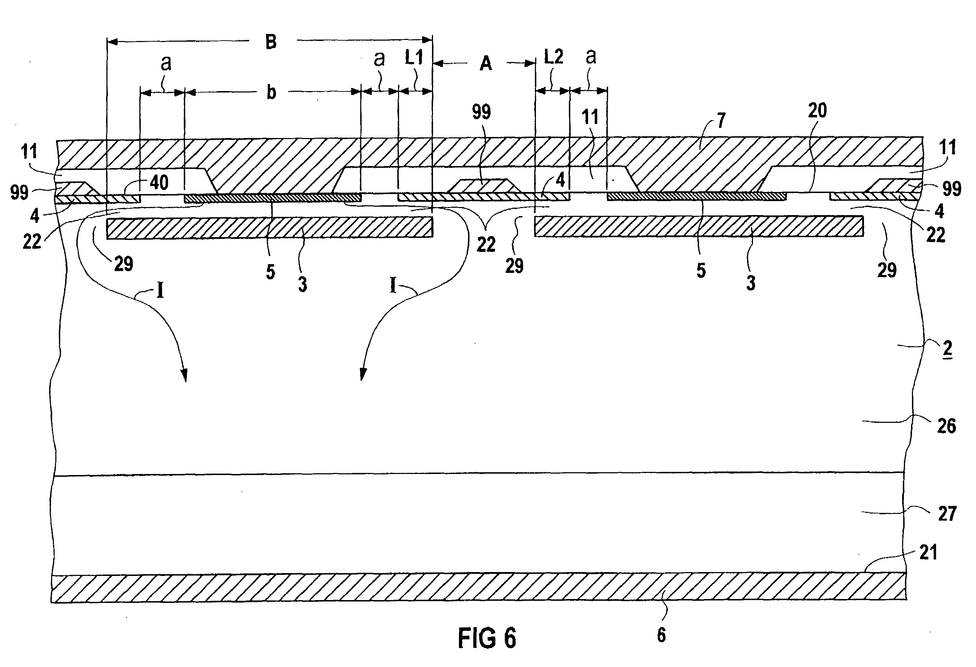

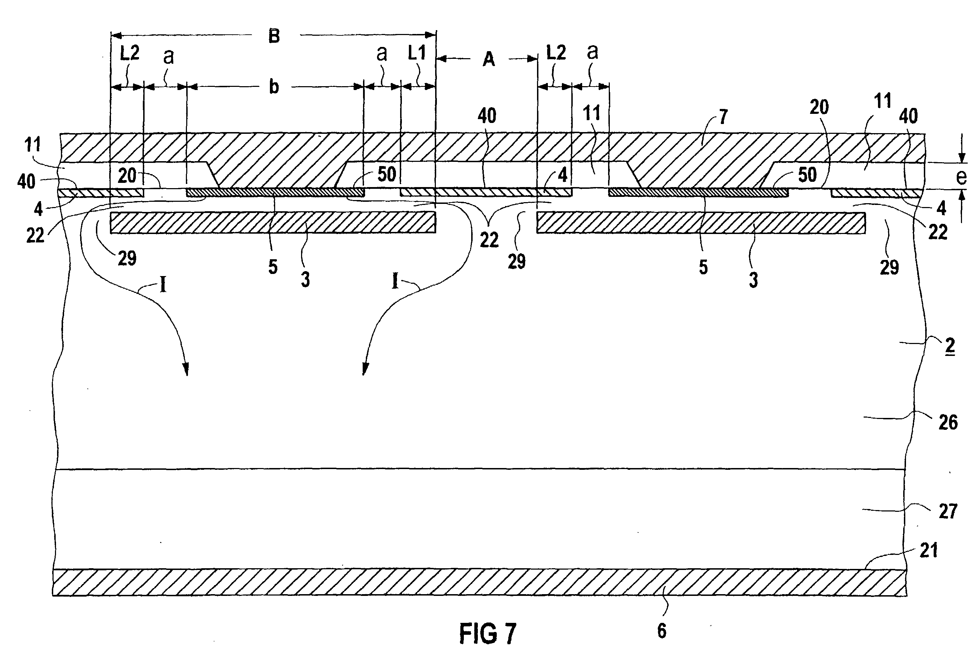

Die FIG 6 und 7 zeigen jeweils eine Halbleiteranordnung, bei der das erste Halbleitergebiet 2 aus einem Substrat 27 und einer darauf angeordneten, epitaktisch aufgewachsenen Halbleiterschicht 26 vom gleichen Leitungstyp und im allgemeinen einer niedrigeren Ladungsträgerkonzentration wie bzw. als das Substrat 27 zusammengesetzt ist. An der Oberfläche 20 der Halbleiterschicht 26 sind mehrere gleich, aber vorzugsweise höher als die Halbleiterschicht 26 dotierte Kontaktgebiete 5 zueinander beabstandet angeordnet, von denen nur zwei dargestellt sind. Unterhalb der Kontaktgebiete 5 ist in der Halbleiterschicht 26 jeweils ein zur Halbleiterschicht 26 entgegengesetzt dotiertes zweites Halbleitergebiet 3 oder jeweils ein Teilbereich eines zusammenhängenden dritten Halbleitergebietes 3 vergraben. Zwischen den Kontaktgebieten 5 sind jeweils in einem lateralen Abstand und vorzugsweise in einem gleichen Abstand a ein drittes, entgegengesetzt zur Halbleiterschicht 26 dotiertes Halbleitergebiet 4 an der Oberfläche 20 der Halbleiterschicht 26 angeordnet. Der laterale Abstand a der Kontaktgebiete 5 von den dritten Halbleitergebieten 4 liegt im allgemeinen zwischen etwa 1 µm und etwa 3µm. Die Kontaktgebiete 5 sind durch eine elektrisch leitende Schicht, vorzugsweise aus Metall oder Polysilicium, als erste Elektrode 7 kontaktiert.

Die Halbleitergebiete 3 und 4 verlaufen jeweils im wesentlichen lateral zur Oberfläche 20 des ersten Halbleitergebiets 2. Jeweils ein Halbleitergebiet 4 überlappt in einer Projektion entlang einer Richtung senkrecht zur Oberfläche 20 mit jeweils zwei der Halbleitergebiete 3 und jedes Halbleitergebiet 3 mit jeweils zwei der Halbleitergebiete 4. Dadurch sind wie in FIG 4 und 5 wieder lateral verlaufende Kanalgebiete 22 der lateralen Kanallängen L1 bzw. L2 in der Halbleiterschicht 26 gebildet zwischen jeweils einem zweiten Halbleitergebiet 3 und jeweils einem dritten Halbleitergebiet 4. Die laterale Ausdehnung B der vergrabenen zweiten Halbleitergebiete 3 ist B = b + 2a + L1 + L2. Auf der von der Halbleiterschicht 26 abgewandten Seite des Substrats 27 als zweite Oberfläche 21 des ersten Halbleitergebiets 2 ist wieder eine zweite Elektrode 6 angeordnet. Zwischen der Elektrode 6 und der Elektrode 7 wird die Betriebsspannung der Halbleiteranordnung angelegt. Die vergrabenen Halbleitergebiete 3 sind lateral voneinander beabstandet, vorzugsweise mit gleichem Abstand A, oder es sind in einem zusammenhängenden zweiten Halbleitergebiet 3 Öffnungen mit jeweils einer lateralen Ausdehnung A gebildet. Zwischen den zweiten Halbleitergebieten 3 ist dadurch jeweils ein Kanalgebiet 29 des ersten Halbleitergebiets 2 von der lateralen Ausdehnung A und der vertikalen Ausdehnung D gebildet, das im wesentlichen vertikal zur Oberfläche 20 verläuft. Der halbleitende Bereich in jedem Kanalgebiet 29 ist lateral begrenzt durch die nicht dargestellten Verarmungszonen der von der Halbleiterschicht 26 und den zweiten Halbleitergebieten 3 gebildeten p-n-Übergänge. Die laterale Ausdehnung A der vertikalen Kanalgebiete 29 ist vorzugsweise so klein gewählt, daß die zwischen den beiden Elektroden 6 und 7 anlegbare maximale Sperrspannung (Rückwärtsspannung) zumindest weitgehend der maximalen Volumensperrspannung entspricht, die der p-n-Übergang zwischen den Halbleitergebieten 2 und 3 an der Unterseite der zweiten Halbleitergebiete 3 tragen kann. Dies entspricht einem zumindest weitgehend planaren Verlauf der Äquipotentiallinien im Sperrfall (reduzierter Spannungsdurchgriff). Typische Werte für die laterale Ausdehnung A liegen zwischen 1 µm und 10 µm. Bei Anlegen einer in Vorwärtsrichtung gepolten Betriebsspannung fließt zwischen der Elektrode 7 und der Elektrode 6 ein Strom I entlang der dargestellten Pfeile, der zunächst durch die lateralen Kanalgebiete 22 und danach in praktisch vertikaler Richtung zur Oberfläche 20 durch die vertikalen Kanalgebiete 29 in der Halbleiterschicht 26 und dann im wesentlichen vertikal durch die Halbleiterschicht 26 und das Substrat 27 zur zweiten Elektrode 6 verläuft.

In FIG 6 ist nun jedes dritte Halbleitergebiet 4 mit einer Steuerelektrode (Gateelektrode) 99 kontaktiert, die unter einem Isolatorgebiet 11 vergraben ist, das die Steuerelektrode 99 oder die Steuerelektroden 99 elektrisch von der ersten Elektrode 7 isoliert. Durch Anlegen eines Steuerpotentials an diese Steuerelektrode 99 kann die Ausdehnung der Verarmungszone des p-n-Übergangs zwischen dem dritten Halbleitergebiet 4 und dem ersten Halbleitergebiet 2 verändert werden und damit die Leitfähigkeit der Kanalgebiete 22 gesteuert werden.

Im Gegensatz zu der aktiven (steuerbaren) Ausführungsform gemäß FIG 6 ist bei der passiven (nicht steuerbaren) Halbleiteranordnung gemäß FIG 7 auf der gesamten freien, nicht an das erste Halbleitergebiet 2 angrenzenden Oberfläche 40 des dritten Halbleitergebiet 4 ein Isolatorgebiet 11 angeordnet, das auch einen angrenzenden Randbereich des Kontaktgebietes 5 bedeckt. Dieses Isolatorgebiet 11 isoliert nun das dritte Halbleitergebiet 4 elektrisch und verhindert ein Abfließen von aus der Verarmungszone des p-n-Übergangs in eine Raumladungszone im dritten Halbleitergebiet 4 diffundierten Ladungen (im dargestellten Fall Elektronen) aus dem dritten Halbleitergebiet 4. Die Leckströme des Isolatorgebiets 11 sollten möglichst gering sein, um eine gute Ladungsspeicherung im dritten Halbleitergebiet 4 zu gewährleisten. Eine weitere Funktion des Isolatorgebiets 11 ist die elektrische Isolation des dritten Halbleitergebietes 4 von der ersten Elektrode 7. Sowohl bei SiC als auch bei Si als Halbleiter wird für das Isolatorgebiet 11 vorzugsweise das Dielektrikum Siliciumdioxid (SiO₂) verwendet, das insbesondere thermisch gewachsen wird. Thermisches Oxid weist hervorragende Isolationseigenschaften auf und kann auf SiC durch Trocken- oder Naßoxidation bei Temperaturen über etwa 1000°C erzeugt werden.

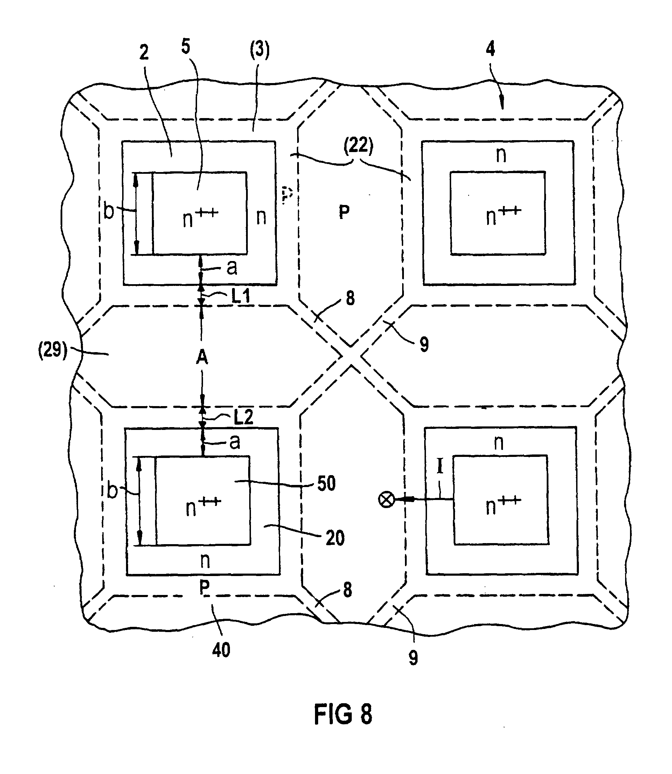

FIG 8 zeigt eine Ausführungsform einer Halbleiteranordnung, die insbesondere gemäß FIG 6 oder FIG 7 im Querschnitt ausgebildet sein könnte, in einer Draufsicht auf die Halbleiteroberfläche ohne Elektroden und Isolatoren. In einem Zelldesign sind mehrere wenigstens annähernd quadratische Zellen vorgesehen aus jeweils einem als Quadrat der Seitenlänge b gebildeten und n⁺⁺-dotierten Sourcegebiet als Kontaktgebiet 5, das in einer n-dotierten Halbleiterschicht als erstem Halbleitergebiet 2 implantiert ist, einem das n⁺⁺-Kontaktgebiet 5 in einem Abstand a umgebenden p-dotierten dritten Halbleitergebiet 4 und einem unterhalb des Kontaktgebietes 5 durch Implantation vergrabenen, p-dotierten zweiten Halbleitergebiet 3, das gestrichelt dargestellt ist. Das dritte Halbleitergebiet 4 mit der Oberfläche 40 ist vorzugsweise an der gesamten Oberfläche 20 des ersten Halbleitergebietes 2 implantiert mit Ausnahme der quadratischen Aussparungen für die Kontaktgebiete 5 mit den Oberflächen 50 und die die Kontaktgebiete 5 umgebenden Teilbereiche der Oberfläche 20 des ersten Halbleitergebietes 2. In dem quadratringförmigen Überlappungsbereich der Breite L1 oder L2 ist unterhalb des dritten Halbleitergebietes 4 und oberhalb des zweiten Halbleitergebietes 3 wieder jeweils ein Kanalgebiet 22 gebildet. Um die vergrabenen zweiten Halbleitergebiete 3 auf gemeinsames Potential zu legen, sind diese zweiten Halbleitergebiete 3 über insbesondere kreuzförmig verlaufende p-dotierte Verbindungen 8 und 9 im ersten Halbleitergebiet 2 miteinander verbunden. Zwischen den Verbindungen 8 und 9 und den benachbarten dritten Halbleitergebieten 3 sind jeweils ein durchgehendes, in etwa in Form einer Raute der Breite A und vertikal zur Oberfläche 40 bzw. 20 verlaufendes Kanalgebiet 29 im ersten Halbleitergebiet 2 unterhalb des dritten Halbleitergebietes 4 angeordnet. Der Strom I fließt von den Sourcegebieten (Kontaktgebieten) 5 zunächst etwa lateral (waagrecht, horizontal) durch das laterale Kanalgebiet 22 und anschließend annähernd vertikal durch die benachbarten vertikalen Kanalgebiete 29.

Anstelle eines Zelldesigns kann auch eine kammartige Topologie vorgesehen sein. Die Ausführungsformen gemäß den FIG 4 bis 8 können auch mutatis mutandis miteinander kombiniert werden.

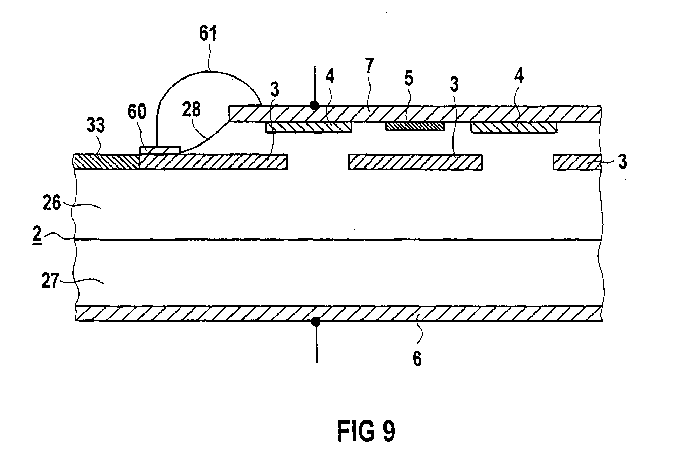

FIG 9 zeigt eine Weiterbildung einer aus FIG 5 und 7 kombinierten Ausführungsform. Die Halbleiterschicht 26 ist an ihrem Rand durch Abtragen von Halbleitermaterial, beispielsweise durch einen Ätzprozeß, bis zu dem zusammenhängenden, vergrabenen zweiten Halbleitergebiet 3 hinunter entfernt. Auf der freigelegten Oberfläche des zweiten Halbleitergebietes 3 ist ein Kontakt 60 aufgebracht. Dieser Kontakt 60 ist über eine elektrische Verbindung 61 mit der ersten Elektrode 7 elektrisch verbunden. Über diese elektrische Verbindung 61 sind die zweiten Halbleitergebiete 3 an die dritten Halbleitergebiete 4 an der Oberfläche 20 angekoppelt. Die elektrische Verbindung 61 kann auf der Halbleiteranordnung integriert sein oder auch eine externe Verdrahtung, insbesondere über einen Schaltkreis, sein. Durch die Wahl der elektrischen Impedanz dieser elektrischen Verbindung 61 kann eine definierte Relaxationszeit (Ladungsabflußzeit) der im zweiten Halbleitergebiet 3 gespeicherten Ladungen im Kurzschlußfall eingestellt werden. Bei einem höheren ohmschen (reellen) Anteil dieser Impedanz ist die Ladungsspeicherzeit größer und damit der Begrenzungsstrom I_{B} der Halbleiteranordnung kleiner. Bei einem kleineren Widerstand der Verbindung 61 ist die Ladungsspeicherzeit kleiner und ein schnelleres Schalten nach einem Kurzschluß möglich, jedoch ist der Begrenzungsstrom höher. Im allgemeinen weist die elektrische Verbindung 61 einen höheren elektrischen Widerstand als die erste Elektrode 7 auf und kann dazu eine höherohmige Polysilicium-Leitungsstrecke umfassen. Im Anschluß an das freigelegte zweite Halbleitergebiet 23 ist ein den gleichen Leitungstyp, jedoch im allgemeinen eine niedrigere Ladungsträgerkonzentration als das zweite Halbleitergebiet 3 aufweisender, flächiger Randabschluß 33 vorgesehen zur Reduzierung der Feldstärke an der Oberfläche. In Abwandlung zu FIG 9 kann die Kontaktierung der vergrabenen zweiten Halbleitergebiete 3 auch in einem inneren Bereich der Halbleiteranordnung erfolgen. Die Ausführungsformen mit Schottky-Kontakten und die Ausführungsformen mit zusätzlichen p-n-Übergängen mit den dritten Halbleitergebieten 4 an der Oberfläche 20 des ersten Halbleitergebietes 2 können auch miteinander kombiniert werden, indem zur Begrenzung des elektrischen Durchgriffs zur ersten Elektrode 7 nebeneinander Schottky-Kontakte und zusätzliche p-n-Übergänge an derselben Oberfläche 20 des ersten Halbleitergebietes 2 vorgesehen werden.

Die bisher beschriebenen Halbleiteranordnungen sind unipolare Bauelemente, die in hervorragender Weise zur Begrenzung von Kurzschlußgleichströmen geeignet sind und dabei eigensicher auch ohne Ansteuerung (passiv) arbeiten. Durch die Auslegung der Halbleiteranordnung als (Gleich-)Strombegrenzer kann ein gewünschter Sättigungsstrom I_{Sat} eingestellt werden, der oberhalb eines Nennstrombereiches und auch eines regulären, noch zu tolerierenden Überstrombereiches liegt und ab dem die Halbleiteranordnung den Strom selbsttätig unter Aufnahme von Spannung auf den niedrigeren Sperrstrom I_{B} begrenzt.

Für das besonders vorteilhafte Halbleitermaterial SiC werden in allen Ausführungsformen im allgemeinen folgende Dotierstoffkonzentrationen gewählt: Für das erste Halbleitergebiet 2, insbesondere die Halbleiterschicht 26, in einem Bereich zwischen etwa 2 · 10¹⁷ cm⁻³ (für eine Sperrspannung von etwa 60 V) über etwa 2 · 10¹⁶ cm⁻³ (für eine Sperrspannung von etwa 700 V) bis zu etwa 6 · 10¹⁵ cm⁻³ (für eine Sperrspannung von etwa 1200 V), für das Substrat 27 auch deutlich mehr als 10¹⁸ cm⁻³ und für die zweiten Halbleitergebiete 3 und die dritten Halbleitergebiete 4 zwischen etwa 1 · 10¹⁸ cm⁻³ und etwa 2 · 10¹⁹ cm⁻³, vorzugsweise etwa 5 · 10¹⁸ cm⁻³ sowie für das Kontaktgebiet 5 über etwa 1 · 10¹⁹ cm⁻³. In Silicium sind diese Dotierkonzentrationen im allgemeinen jeweils durch etwa 100 zu dividieren (um zwei Größenordnungen kleiner).

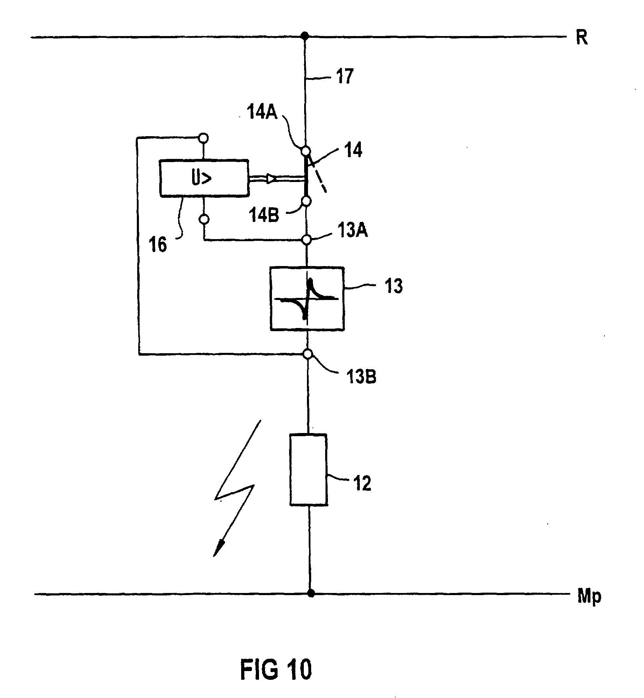

FIG 10 veranschaulicht eine Schalteinrichtung in einem Leitungsabzweig 17 zwischen einer Phase R und Erdpotential Mp eines elektrischen Wechselspannungsversorgungsnetzes, beispielsweise einer Gebäudeinstallation, für einen elektrischen Verbraucher 12. Die Schalteinrichtung umfaßt einen elektronischen Wechselstrombegrenzer 13, der insbesondere gemäß einer der FIG 1 bis 3 in Verbindung mit einer der FIG 4 bis 9 ausgebildet sein kann, einen Überspannungsauslöser 16, der den Spannungsabfall zwischen zwei Abgriffspunkten 13A und 13B des Wechselstrombegrenzers 13 abgreift, und ein in Reihe zum Wechselstrombegrenzer 13 vor die Last 12 in den Leitungsabzweig 17 geschaltetes Schaltrelais 14. Das Schaltrelais 14 wird von dem Überspannungsauslöser 16 bei Überschreiten einer Grenzspannung am Strombegrenzer 13 ausgelöst (geöffnet) zur galvanischen Trennung des Verbrauchers 12 vom Netz (R) im Kurzschlußfall. Das Schaltrelais 14 muß dabei nicht besonders schnell sein noch werden seine Kontakte durch Lichtbögen bei der Strombegrenzung beansprucht, da der elektronische Wechselstrombegrenzer 13 gemäß der Erfindung sehr schnell in deutlich weniger als einer Millisekunde den Strom begrenzt.

## Patentansprüche

1. Vorrichtung zum Begrenzen elektrischer Wechselströme mit
a) wenigstens einer in den Strompfad des Wechselstromes geschalteten passiven Halbleiteranordnung (H1,H2,H3), die so ausgebildet ist, daß sie bei Anliegen einer Vorwärtsspannung mit einer vorgegebenen Polarität von einem Vorwärtsstrom durchflossen wird, der mit ab Spannung Null steigender Vorwärtsspannung bis auf einen Sättigungsstrom bei einer zugehörigen Sättigungsspannung monoton zunimmt und bei einer oberhalb der Sättigungsspannung liegenden Vorwärtsspannung auf einen Begrenzungsstrom unterhalb des Sättigungsstromes begrenzt wird, und bei Anliegen einer Rückwärtsspannung mit einer zur Polarität der Vorwärtsspannung entgegengesetzten Polarität von einem Rückwärtsstrom durchflossen wird, der mit ab Spannung Null steigender Rückwärtsspannung bis zu einer vorgegebenen Rückwärtsdurchbruchsspannung monoton zunimmt und bei Überschreiten der Rückwärtsdurchbruchsspannung aufgrund eines Ladungsträgerdurchbruchs deutlich stärker ansteigt,
b) einer unter Verwendung von Dioden realisierten Schutzschaltung, die verhindert, daß die Halbleiteranordnung (H1,H2,H3) in der in ihrer Rückwärtsrichtung gepolten Halbwelle des Wechselstromes, insbesondere in einem Überstrom- oder Kurzschlußfall, in die Rückwärtsdurchbruchsspannung getrieben wird.

2. Vorrichtung nach Anspruch 1 mit
a) einer ersten Halbleiteranordnung (H1) und einer zweiten Halbleiteranordnung (H2), die antiseriell in den Strompfad des zu begrenzenden Wechselstromes geschaltet sind,
wobei
b) die Schutzschaltung für diese beiden Halbleiteranordnungen (H1,H2) eine erste, antiparallel zur ersten Halbleiteranordnung (H1) geschaltete Diode (D1) und eine zweite, antiparallel zur zweiten Halbleiteranordnung (H2) geschaltete zweite Diode (D2) umfaßt, derart daß
c) der Wechselstrom in einem Nennstrombereich zumindest überwiegend und vorzugsweise praktisch vollständig durch die beiden Halbleiteranordnungen (H1,H2) fließt und
d) in einem Überstromfall oder Kurzschlußfall der Wechselstrom in jeder Halbwelle einer ersten oder zur ersten entgegengesetzten, zweiten Polarität bis auf den Sättigungsstrom bei der Sättigungsspannung an der ersten bzw. zweiten Halbleiteranordnung (H1 bzw. H2) monoton zunimmt und bei einer oberhalb der zugehörigen Sättigungsspannung liegenden Spannung der ersten bzw. zweiten Polarität an der ersten bzw. zweiten Halbleiteranordnung (H1 bzw. H2) von der ersten bzw. zweiten Halbleiteranordnung (H1 bzw. H2) auf den Begrenzungsstrom begrenzt wird und dabei praktisch ausschließlich durch die erste bzw. zweite Halbleiteranordnung (H1 bzw. H2) und zumindest überwiegend durch die zweite bzw. erste Diode (D2 bzw. D1) fließt.

3. Vorrichtung nach Anspruch 1 oder Anspruch 2 mit
a) einer ersten Halbleiteranordnung (H1) und einer zweiten Halbleiteranordnung (H2), die antiseriell in den Strompfad des zu begrenzenden Wechselstromes geschaltet sind,
wobei
b) die Schutzschaltung für diese beiden Halbleiteranordnungen (H1,H2) eine erste, antiparallel zur ersten Halbleiteranordnung (H1) geschaltete Diode (D1) und eine zweite, antiparallel zur zweiten Halbleiteranordnung (H2) geschaltete zweite Diode (D2) umfaßt, derart daß
c) die maximale Sperrspannung jeder Diode (D1,D2) mindestens so groß wie die máximale Vorwärtsspannung beim Begrenzungsstrom der zugehörigen, antiparallel geschalteten Halbleiteranordnung (H1, H2) ist, und
d) die Durchlaßschwellspannung jeder Diode (D1,D2) betragsmäßig kleiner als die Rückwärtsdurchbruchsspannung der zugehörigen, antiparallel geschalteten Halbleiteranordnung (H1,H2) ist und zudem kleiner als die Sättigungsspannung der zu der jeweils anderen Diode (D2,D1) antiparallel geschalteten Halbleiteranordnung (H2,H1) ist.

4. Vorrichtung nach Anspruch 1 mit
a) einer ersten Halbleiteranordnung (H4) und einer zweiten Halbleiteranordnung (H5), und mit
b) einer Schutzschaltung für diese beiden Halbleiteranordnungen (H4,H5), die eine erste, in Reihe zur ersten Halbleiteranordnung (H4) geschaltete Diode (D8) und eine zweite in Reihe zur zweiten Halbleiteranordnung (H5) geschaltete zweite Diode (D7) umfaßt, wobei
c) die Reihenschaltung aus erster Diode (D8) und erster Halbleiteranordnung (H4) antiparallel zur Reihenschaltung aus zweiter Diode (D7) und zweiter Halbleiteranordnung (H5) geschaltet ist und
d) die maximale Sperrspannung jeder Diode (D8,D7) mindestens so groß wie die maximale Rückwärtsspannung der zugehörigen, in Reihe geschalteten Halbleiteranordnung (H4,H5) ist.

5. Vorrichtung nach Anspruch 1 mit
a) einer einzigen Halbleiteranordnung (H3), die in den Strompfad des zu begrenzenden Wechselstromes geschaltet ist,
wobei
b) die Schutzschaltung für diese Halbleiteranordnung (H3) zwei Reihenschaltungen aus jeweils zwei Dioden (D3 und D4, D5 und D6) enthält, die jeweils antiparallel zur Halbleiteranordnung (H3) geschaltet sind, derart, daß
c) der Wechselstrom bei jeder der beiden Polaritäten im wesentlichen durch eine der zwei bei der jeweiligen Polarität in Durchlaßrichtung liegenden Dioden (D6,D4), danach durch die Halbleiteranordnung (H3) in deren Vorwärtsrichtung und anschließend durch die weitere, in Durchlaßrichtung liegende Diode (D3,D5) fließt.

6. Vorrichtung nach Anspruch 1 oder Anspruch 5 mit
a) einer einzigen Halbleiteranordnung (H3),
wobei
b) die Schutzschaltung eine Graetz-Brückenschaltung aus vier Dioden (D3,D4,D5,D6) umfaßt, in deren Diagonale die Halbleiteranordnung (H3) geschaltet ist und an deren andere Diagonale die dem zu begrenzenden Wechselstrom zugehörige Wechselspannung anlegbar ist,
wobei
c) die maximale Sperrspannung jeder Diode (D3 bis D6) mindestens so groß wie die maximale Vorwärtsspannung beim Begrenzungsstrom der Halbleiteranordnung (H1,H2) ist.

7. Vorrichtung nach einem der Ansprüche 2 bis 6, bei der wenigstens eine der Dioden (D1 bis D8) eine p-n-Gleichrichterdiode ist.

8. Vorrichtung nach einem der Ansprüche 2 bis 7, bei der wenigstens eine der Dioden (D1 bis D8) eine Schottky-Diode ist.

9. Vorrichtung nach einem der Ansprüche 2 bis 8, bei der wenigstens eine Diode (D1 bis D8) in Silicium (Si) gebildet ist.

10. Vorrichtung nach einem der vorhergehenden Ansprüche, bei der jede Halbleiteranordnung (H1 bis H5) mit einem Halbleitermaterial gebildet ist, der einen Bandabstand von wenigstens 2 eV aufweist.

11. Vorrichtung nach Anspruch 10, bei dem als Halbleitermaterial Siliciumcarbid (SiC) vorgesehen ist.

12. Vorrichtung nach einem der Ansprüche 2 bis 11, bei der wenigstens eine Halbleiteranordnung (H1 bis H5) und wenigstens eine Diode (D1 bis D8) auf einem Halbleitersubstrat integriert sind.

13. Vorrichtung nach einem der vorhergehenden Ansprüche, bei der jede Halbleiteranordnung (H1 bis H5) 9
a) eine erste Elektrode (7) und eine zweite Elektrode (6) sowie
b) ein erstes Halbleitergebiet (2) mit wenigstens einem im Strompfad zwischen der ersten Elektrode (7) und der zweiten Elektrode (6) liegenden Kanalgebiet (22), das bei Erreichen des Sättigungsstromes von wenigstens einer Verarmungszone (23,24) abgeschnürt wird,
umfaßt.

14. Vorrichtung nach Anspruch 13, bei der
a) die erste Elektrode (7) das erste Halbleitergebiet (2) auf wenigstens einem an einer ersten Oberfläche (20) des ersten Halbleitergebietes (2) angeordneten Kontaktgebiet (5) ohmsch kontaktiert,
b) wenigstens eine der Verarmungszonen (23,24) die Verarmungszone eines p-n-Übergangs zwischen dem ersten Halbleitergebiet (2) und einem zweiten Halbleitergebiet (3) ist und
c) das zweite Halbleitergebiet (3) innerhalb des ersten Halbleitergebietes (2) unterhalb des Kontaktgebiets (5) angeordnet ist und sich in allen Richtungen parallel zur ersten Oberfläche (20) des ersten Halbleitergebiets (2) weiter erstreckt als das Kontaktgebiet (5).

15. Vorrichtung nach Anspruch 14, bei der
a) das erste Halbleitergebiet (2) an seiner ersten Oberfläche (20) mehrere Kontaktgebiete (5) aufweist,
b) unterhalb der Kontaktgebiete (5) ein zusammenhängendes zweites Halbleitergebiet (3) angeordnet ist, das in allen Richtungen parallel zur ersten Oberfläche (20) des ersten Halbleitergebietes (2) weiter ausgedehnt ist als die Gesamtheit der Kontaktgebiete (5) und
c) durch Öffnungen in dem zusammenhängenden zweiten Halbleitergebiet (3) jeweils Kanalgebiete (29) des ersten Halbleitergebietes (2) verlaufen, die im Strompfad elektrisch in Reihe zu jeweils wenigstens einem der den Kontaktgebieten (5) zugeordneten Kanalgebieten (22) liegen.

16. Vorrichtung nach Anspruch 14, bei der
a) unterhalb jedes Kontaktgebietes (5) ein zugehöriges zweites Halbleitergebiet (3) im ersten Halbleitergebiet (2) angeordnet ist und
b) zwischen den den Kontaktgebieten (5) zugeordneten zweiten Halbleitergebieten (3) zusätzliche Kanalgebiete (29) des ersten Halbleitergebietes (2) verlaufen, die im Strompfad elektrisch in Reihe zu jeweils wenigstens einem der den Kontaktgebieten (5) zugeordneten Kanalgebieten (22) liegen.

17. Vorrichtung nach einem der Ansprüche 13 bis 16, bei der wenigstens eine der Verarmungszonen (70) die Verarmungszone eines Schottky-Kontakts ist.

18. Vorrichtung nach Anspruch 17, bei der der Schottky-Kontakt mit der ersten Elektrode (7) und einem außerhalb des wenigstens einen Kontaktgebietes (5) liegenden Bereich des ersten Halbleitergebietes (2) gebildet ist.

19. Vorrichtung nach einem der Ansprüche 13 bis 18, bei der wenigstens eine der Verarmungszonen (24) die Verarmungszone eines p-n-Übergangs ist, der zwischen dem ersten Halbleitergebiet (2) und einem dritten Halbleitergebiet (4), das an der ersten Oberfläche (20) des ersten Halbleitergebietes (2) angeordnet ist, gebildet ist.

20. Vorrichtung nach Anspruch 19, bei der das dritte Halbleitergebiet (4) mit einer Steuerelektrode (99) zum Steuern des elektrischen Widerstandes im Kanalgebiet (22) durch Anlegen einer Steuerspannung kontaktiert ist.

21. Vorrichtung nach Anspruch 19, bei der das dritte Halbleitergebiet (4) an seiner nicht an das erste Halbleitergebiet (2) angrenzenden Oberfläche (40) mit einem Isolatorgebiet (11) bedeckt ist, so daß Ladungen im dritten Halbleitergebiet (4) speicherbar sind.

22. Vorrichtung nach Anspruch 19, bei der die erste Elektrode (7) außer dem wenigstens einen Kontaktgebiet (5) des ersten Halbleitergebiet (2) auch das dritte Halbleitergebiet (4) an seiner nicht an das erste Halbleitergebiet (2) angrenzenden Oberfläche (40) kontaktiert.

23. Vorrichtung nach Anspruch 22, bei der die erste Elektrode (7) zusätzlich an jedes zweite Halbleitergebiet (3) derart elektrisch angekoppelt ist, daß sich eine vorgegebene Relaxationszeit für gespeicherten Ladungen im zweiten Halbleitergebiet (3) ergibt.

24. Vorrichtung nach einem der vorhergehenden Ansprüche, bei der der Sättigungsstrom jeder Halbleiteranordnung (H1 bis H5) wenigstens das Fünffache des Begrenzungsstromes beträgt.

## Claims

1. A device for limiting alternating electric currents, with
a) at least one passive semiconductor arrangement (H1, H2, H3) connected into the current path of the alternating current, which is configured in such a way that when a forward voltage with a predetermined polarity is applied a forward current flows through it which with forward voltage increasing from zero voltage increases monotonously up to a saturation current at an associated saturation voltage and at a forward voltage lying above the saturation voltage is limited to a limiting current below the saturation current, and when a reverse voltage with a polarity opposite to the polarity of the forward voltage is applied a reverse current flows through it which with reverse voltage increasing from zero voltage increases monotonously up to a predetermined reverse breakdown voltage and rises in distinctly more intense manner when the reverse breakdown voltage is exceeded by reason of a charge-carrier breakdown,
b) a protective circuit realised by the use of diodes, which prevents the semiconductor arrangement (H1, H2, H3) from being driven into the reverse breakdown voltage in the half-wave of the alternating current which is polarized in its reverse direction, particularly in the event of an overcurrent or short circuit.

2. Device according to Claim 1 with
a) a first semiconductor arrangement (H1) and a second semiconductor arrangement (H2) which are connected antiserially into the current path of the alternating current to be limited,
whereby
b) the protective circuit for these two semiconductor arrangements (H1, H2) comprises a first diode (D1) connected in antiparallel relative to the first semiconductor arrangement (H1) and a second diode (D2) connected in antiparallel relative to the second semiconductor arrangement (H2), in such a manner that
c) the alternating current flows in a rated-current range at least predominantly and preferably practically totally through the two semiconductor arrangements (H1, H2) and
d) in the event of an overcurrent or a short circuit the alternating current in each half-wave of a first polarity, or of a second polarity opposite to the first, increases monotonously up to the saturation current at the saturation voltage at the first or second semiconductor arrangement (H1 or H2) and at a voltage with the first or second polarity lying above the associated saturation voltage at the first or second semiconductor arrangement (H1 or H2) is limited by the first or second semiconductor arrangement (H1 or H2) to the limiting current and in the process flows practically exclusively through the first or second semiconductor arrangement (H1 or H2) and at least predominantly through the second or first diode (D2 or D1).

3. Device according to Claim 1 or Claim 2 with
a) a first semiconductor arrangement (H1) and a second semiconductor arrangement (H2) which are connected antiserially into the current path of the alternating current to be limited,
whereby
b) the protective circuit for these two semiconductor arrangements (H1, H2) comprises a first diode (D1) connected in antiparallel relative to the first semiconductor arrangement (H1) and a second diode (D2) connected in antiparallel relative to the second semiconductor arrangement (H2), in such a manner that
c) the maximum blocking-state voltage of each diode (D1, D2) is at least as high as the maximum forward voltage in the case of the limiting current of the associated semiconductor arrangement (H1, H2) connected in antiparallel, and
d) the conducting-state threshold voltage of each diode (D1, D2) is smaller in value terms than the reverse breakdown voltage of the associated semiconductor arrangement (H1, H2) connected in antiparallel and in addition is smaller than the saturation voltage of the semiconductor arrangement (H2, H1) connected in antiparallel relative to the respective other diode (D2, D1).

4. Device according to Claim 1 with
a) a first semiconductor arrangement (H4) and a second semiconductor arrangement (H5), and with
b) a protective circuit for these two semiconductor arrangements (H4, H5), which comprises a first diode (D8) connected in series with the first semiconductor arrangement (H4) and a second diode (D7) connected in series with the second semiconductor arrangement (H5), whereby
c) the series circuit consisting of first diode (D8) and first semiconductor arrangement (H4) is connected in antiparallel relative to the series circuit consisting of second diode (D7) and second semiconductor arrangement (H5) and
d) the maximum blocking-state voltage of each diode (D8, D7) is at least as high as the maximum reverse voltage of the associated semiconductor arrangement (H4, H5) connected in series:

5. Device according to Claim 1 with
a) a single semiconductor arrangement (H3) which is connected into the current path of the alternating current to be limited,
whereby
b) the protective circuit for this semiconductor arrangement (H3) contains two series circuits each consisting of two diodes (D3 and D4, D5 and D6) which are each connected in antiparallel relative to the semiconductor arrangement (H3), in such a manner that
c) the alternating current for each of the two polarities flows substantially through one of the two diodes (D6, D4) situated in the conducting direction for the respective polarity, then through the semiconductor arrangement (H3) in the forward direction thereof and subsequently through the further diode (D3, D5) situated in the conducting direction.

6. Device according to Claim 1 or Claim 5 with
a) a single semiconductor arrangement (H3),
whereby
b) the protective circuit comprise a Graetz bridge circuit consisting of four diodes (D3, D4, D5, D6), in the diagonal of which the semiconductor arrangement (H3) is connected and at the other diagonal of which the a.c. voltage associated with the alternating current to be limited is capable of being applied,
whereby
c) the maximum blocking-state voltage of each diode (D3 to D6) is at least as high as the maximum forward voltage in the case of the limiting current of the semiconductor arrangement (H1, H2).

7. Device according to one of Claims 2 to 6, wherein at least one of the diodes (D1 to D8) is a p-n rectifier diode.

8. Device according to one of Claims 2 to 7, wherein at least one of the diodes (D1 to D8) is a Schottky diode.

9. Device according to one of Claims 2 to 8, wherein at least one diode (D1 to D8) is formed in silicon (Si).

10. Device according to one of the preceding claims, wherein each semiconductor arrangement (H1 to H5) is formed with a semiconductor material that exhibits a band gap of at least 2 eV.

11. Device according to Claim 10, wherein silicon carbide (SiC) is provided by way of semiconductor material.

12. Device according to one of Claims 2 to 11, wherein at least one semiconductor arrangement (H1 to H5) and at least one diode (D1 to D8) are integrated on a semiconductor substrate.

13. Device according to one of the preceding claims, wherein each semiconductor arrangement (H1 to H5) comprises
a) a first electrode (7) and a second electrode (6) as well as
b) a first semiconductor region (2) with at least one channel region (22) which is situated in the current path between the first electrode (7) and the second electrode (6) and which is pinched off when the saturation current of at least one depletion zone (23, 24) is reached.

14. Device according to Claim 13, wherein
a) the first electrode (7) makes ohmic contact with the first semiconductor region (2) on at least one contact region (5) disposed on a first surface (20) of the first semiconductor region (2),
b) at least one of the depletion zones (23, 24) is the depletion zone of a p-n junction between the first semiconductor region (2) and a second semiconductor region (3) and
c) the second semiconductor region (3) is disposed within the first semiconductor region (2) underneath the contact region (5) and extends further in all directions parallel to the first surface (20) of the first semiconductor region (2) than the contact region (5).

15. Device according to Claim 14, wherein
a) the first semiconductor region (2) comprises several contact regions (5) on its first surface (20),
b) underneath the contact regions (5) a coherent second semiconductor region (3) is disposed which is extended further in all directions parallel to the first surface (20) of the first semiconductor region (2) than the totality of the contact regions (5) and
c) through openings in the coherent second semiconductor region (3) there pass, in each case, channel regions (29) of the first semiconductor region (2) which are situated in the current path electrically in series with, in each case, at least one of the channel regions (22) assigned to the contact regions (5).

16. Device according to Claim 14, wherein
a) underneath each contact region (5) an associated second semiconductor region (3) is disposed in the first semiconductor region (2) and .
b) between the second semiconductor regions (3) assigned to the contact regions (5) there extend additional channel regions (29) of the first semiconductor region (2) which are situated in the current path electrically in series with, in each case, at least one of the channel regions (22) assigned to the contact regions (5).

17. Device according to one of Claims 13 to 16, wherein at least one of the depletion zones (70) is the depletion zone of a Schottky contact.

18. Device according to Claim 17, wherein the Schottky contact is formed by the first electrode (7) and a part of the first semiconductor region (2) situated outside the at least one contact region (5).

19. Device according to one of Claims 13 to 18, wherein at least one of the depletion zones (24) is the depletion zone of a p-n junction which is formed between the first semiconductor region (2) and a third semiconductor region (4) which is disposed on the first surface (20) of the first semiconductor region (2).

20. Device according to Claim 19, wherein the third semiconductor region (4) is brought into contact with a control electrode (99) for controlling the electrical resistance in the channel region (22) by applying a control voltage.

21. Device according to Claim 19, wherein the third semiconductor region (4) is covered with an insulator region (11) on its surface (40) not adjoining the first semiconductor region (2), so that charges in the third semiconductor region (4) are capable of being stored.

22. Device according to Claim 19, wherein the first electrode (7) makes contact not only with the at least one contact region (5) of the first semiconductor region (2) but also with the third semiconductor region (4) on its surface (40) not adjoining the first semiconductor region (2).

23. Device according to Claim 22, wherein the first electrode (7) is additionally electrically coupled to every second semiconductor region (3) in such a manner as to result in a predetermined relaxation-time for stored charges in the second semiconductor region (3).

24. Device according to one of the preceding claims, wherein the saturation current of each semiconductor arrangement (H1 to H5) amounts to at least five times the limiting current.

## Revendications

1. Dispositif de limitation de courants électriques alternatifs comprenant
a) au moins un dispositif (H1, H2, H3) à semi-conducteur passif, qui est monté dans le trajet du courant alternatif et qui est constitué de façon que, lors de l'application d'une tension directe d'une polarité prescrite, il y passe un courant direct qui augmente de manière monotone de la tension directe augmentant à partir de la tension nulle jusqu'à un courant de saturation pour une tension de saturation correspondante et, pour une tension directe supérieure à la tension de saturation, est limité à un courant de limitation inférieur au courant de saturation et, lors de l'application d'une tension inverse ayant une polarité opposée à la polarité de la tension directe, il y passe un courant inverse qui augmente de manière monotone de la tension inverse augmentant à partir de la tension nulle jusqu'à une tension de claquage inverse prescrite et, lorsque la tension de claquage inverse est dépassée, augmente d'une manière nettement plus forte en raison d'un passage des porteurs de charge,
b) un circuit de protection réalisé en utilisant des diodes, qui empêche que le dispositif (H1, H2, H3) à semi-conducteur ne fonctionne dans la demi-onde du courant alternatif polarisé dans le sens inverse, notamment dans un cas de surintensité ou de court-circuit, à la tension de claquage inverse.

2. Dispositif suivant la revendication 1, comprenant
a) un premier dispositif (H1) à semi-conducteur et un deuxième dispositif (H2) à semi-conducteur, qui sont montés tête-bêche dans le trajet du courant alternatif à limiter, dans lequel
b) le circuit de protection pour ces deux dispositifs (H1, H2) à semi-conducteur comporte une première diode (D1) montée tête-bêche par rapport au premier dispositif (H1) à semi-conducteur et une deuxième diode (D2) montée tête-bêche par rapport au deuxième dispositif (H2) à semi-conducteur, de façon que
c) le courant alternatif dans une plage de courant nominale, passe, au moins de manière prépondérante et de préférence pratiquement entièrement, par les deux dispositifs (H1, H2) à semi-conducteur et
d) dans un cas de surintensité ou dans un cas de court-circuit, le courant alternatif augmente de manière monotone à chaque demi-onde d'une première ou d'une deuxième polarité opposée à la première jusqu'au courant de saturation à la tension de saturation sur le premier ou le deuxième dispositif (H1 ou H2) à semi-conducteur et, pour une tension supérieure à la tension de saturation correspondante de la première ou de la deuxième polarité sur le premier ou le deuxième dispositif (H1 ou H2) à semi-conducteur, est limité par le premier ou par le deuxième dispositif (H1 ou H2) à semi-conducteur au courant de limitation et ne passe ainsi en pratique que par le premier ou le deuxième dispositif (H1 ou H2) à semi-conducteur et au moins d'une manière prépondérante par la deuxième ou la première diode (D2 ou D1).

3. Dispositif suivant la revendication 1 ou 2, comprenant
a) un premier dispositif (H1) à semi-conducteur et un deuxième dispositif (H2) à semi-conducteur, qui sont montés tête-bêche dans le trajet du courant alternatif à limiter, dans lequel
b) le circuit de protection pour ces deux dispositifs (H1, H2) à semi-conducteur comporte une première diode (D1) montée tête-bêche par rapport au premier dispositif (H1) à semi-conducteur et une deuxième diode (D2) montée tête-bêche par rapport au deuxième dispositif (H2) à semi-conducteur,
c) la tension maximum de blocage de chaque diode (D1, D2) est au moins aussi grande que la tension directe maximum pour le courant de limitation du dispositif (H1, H2) à semi-conducteur correspondant monté tête-bêche et
d) la tension de seuil à l'état passant de chaque diode (D1, D2) est en valeur absolue plus petite que la tension de claquage en sens inverse du dispositif (H1, H2) à semi-conducteur correspondant monté tête-bêche et en outre plus petite que la tension de saturation du dispositif (H2, H1) à semi-conducteur monté tête-bêche par rapport à l'autre diode (D2, D1) respective.

4. Dispositif suivant la revendication 1, comprenant
a) un premier dispositif (H4) à semi-conducteur et un deuxième dispositif (H5) à semi-conducteur,
et comprenant
b) un circuit de protection pour ces deux dispositifs (H4, H5) à semi-conducteur, qui comprend une première diode (D8) montée en série avec le premier dispositif (H4) à semi-conducteur et une deuxième diode (D7) montée en série avec le deuxième dispositif (H5) à semi-conducteur, dans lequel
c) le circuit série constitué de la première diode (D8) et du premier dispositif (H4) à semi-conducteur est monté tête-bêche par rapport au circuit série constitué de la deuxième diode (D7) et du deuxième dispositif (H5) à semi-conducteur et
d) la tension maximum de blocage de chaque diode (D8, D7) est au moins aussi grande que la tension maximum inverse du dispositif (H4, H5) à semi-conducteur correspondant monté en série.

5. Dispositif suivant la revendication 1, comprenant
a) un dispositif (H3) à semi-conducteur unique, qui est monté dans le trajet du courant alternatif à limiter,
dans lequel
b) le circuit de protection de ce dispositif (H3) à semi-conducteur comporte deux circuits série constitués respectivement de deux diodes (D3 et D4, D5 et D6) qui sont montées respectivement tête-bêche par rapport au dispositif (H3) à semi-conducteur, de façon que
c) le courant alternatif pour chacune des deux polarités passe essentiellement par l'une des deux diodes (D6, D4) se trouvant dans le sens passant pour la polarité respective, puis par le dispositif (H3) à semi-conducteur dans son sens direct et ensuite par l'autre diode (D3, D5) se trouvant dans le sens passant.

6. Dispositif suivant la revendication 1 ou la revendication 5, comprenant
a) un dispositif (H3) à semi-conducteur unique,
dans lequel
b) le circuit de protection est un circuit à pont de Graetz constitué de quatre diodes (D3, D4, D5, D6), dans l'une des diagonales duquel est monté le dispositif (H3) à semi-conducteur et dans l'autre diagonale duquel peut être appliquée la tension alternative correspondant au courant alternatif à limiter,
dans lequel
c) la tension maximum de blocage de chaque diode (D3 à D6) est au moins aussi grande que la tension maximum directe pour le courant de limitation du dispositif (H1, H2) à semi-conducteur.

7. Dispositif suivant l'une des revendications 2 à 6, dans lequel au moins l'une des diodes (D1 à D8) est une diode redresseuse p-n.

8. Dispositif suivant l'une des revendications 2 à 7, dans lequel au moins l'une des diodes (D1 à D8) est une diode de Schottky.

9. Dispositif suivant l'une des revendications 2 à 8, dans lequel au moins l'une des diodes (D1 à D8) est en silicium (Si).

10. Dispositif suivant l'une des revendications précédentes, dans lequel chaque dispositif (H1 à H5) à semi-conducteur est en un matériau semi-conducteur qui a une bande interdite d'au moins 2 eV.

11. Dispositif suivant la revendication 10, dans lequel il est prévu du carbure de silicium (SiC) comme matériau semi-conducteur.

12. Dispositif suivant l'une des revendications 2 à 11, dans lequel au moins l'un des dispositifs (H1 à H5) à semi-conducteur et au moins l'une des diodes (D1 à D8) sont intégrés sur un substrat semi-conducteur.

13. Dispositif suivant l'une des revendications précédentes, dans lequel chaque dispositif (H1 à H5) à semi-conducteur comprend
a) une première électrode (7) et une deuxième électrode (6) ainsi que
b) un premier domaine (2) semi-conducteur ayant au moins un domaine (22) de canal se trouvant dans le trajet de courant compris entre la première électrode (7) et la deuxième électrode (6), domaine qui est rétréci lorsqu'est atteint le courant de saturation d'au moins une zone (23, 24) d'appauvrissement.

14. Dispositif suivant la revendication 13, dans lequel
a) la première électrode (7) contacte de manière ohmique le premier domaine (2) semi-conducteur sur au moins un domaine de contact disposé sur une première surface (20) du premier domaine (2) semi-conducteur,
b) au moins l'une des zones (23, 24) d'appauvrissement est la zone d'appauvrissement d'une jonction p-n entre le premier domaine (2) semi-conducteur et un deuxième domaine (3) semi-conducteur et
c) le deuxième domaine (3) semi-conducteur est disposé au sein du premier domaine (2) semi-conducteur en-dessous du domaine (5) de contact et s'étend dans toutes les directions parallèlement à la première surface (20) du premier domaine (2) semi-conducteur plus loin que le domaine (5) de contact.

15. Dispositif suivant la revendication 14, dans lequel
a) le premier domaine (2) semi-conducteur comporte plusieurs domaines (5) de contact sur sa première surface (20),
b) en-dessous des domaines (5) de contact il est prévu un deuxième domaine (3) semi-conducteur d'un seul tenant, qui s'étend dans toutes les directions parallèlement à la première surface (20) du premier domaine (2) semi-conducteur plus loin que l'ensemble des domaines (5) de contact et
c) il passe par des ouvertures ménagées dans le deuxième domaine (3) semi-conducteur d'un seul tenant respectivement des domaines (29) de canal du premier domaine (2) semi-conducteur, qui sont dans le trajet du courant électriquement en série à respectivement au moins l'un des domaines (22) de canal associés aux domaines (5) de canal.

16. Dispositif suivant la revendication 14, dans lequel
a) il est prévu en-dessous de chaque domaine (5) de canal un deuxième domaine (3) semi-conducteur correspondant dans le premier domaine (2) semi-conducteur et
b) il passe, entre les deuxièmes domaines (3) semi-conducteurs associés aux domaines (5) de contact, des domaines (29) de canal supplémentaires du premier domaine (2) semi-conducteur, qui sont électriquement en série dans le trajet du courant avec respectivement au moins l'un des domaines (22) de contact associés aux domaines (5) de contact.

17. Dispositif suivant l'une des revendications 13 à 16, dans lequel au moins l'une des zones (70) d'appauvrissement est la zone d'appauvrissement d'un contact de Schottky.

18. Dispositif suivant la revendication 17, dans lequel le contact de Schottky est formé avec la première électrode (7) et une zone du premier domaine (2) semi-conducteur se trouvant à l'extérieur du au moins un domaine (5) de contact.

19. Dispositif suivant l'une des revendications 13 à 18, dans lequel au moins l'une des zones (24) d'appauvrissement est la zone d'appauvrissement d'une jonction p-n qui est formée entre le premier domaine (2) semi-conducteur et un troisième domaine (4) semi-conducteur qui est prévu sur la première surface (20) du premier domaine (2) semi-conducteur.

20. Dispositif suivant la revendication 19, dans lequel le troisième domaine (4) semi-conducteur est contacté par une électrode (39) de commande destinée à commander la résistance électrique du domaine (22) de canal par application d'une tension de commande.

21. Dispositif suivant la revendication 19, dans lequel le troisième domaine (4) semi-conducteur est recouvert sur sa surface (40) adjacente au premier domaine (2) semi-conducteur d'un domaine (11) isolant, de sorte que des charges peuvent être emmagasinées dans le troisième domaine (4) à semi-conducteur.

22. Dispositif suivant la revendication 19, dans lequel la première électrode (7) contacte en-dehors du au moins un domaine (5) de contact du premier domaine (2) semi-conducteur également le troisième domaine (4) semi-conducteur sur sa surface (40) qui n'est pas adjacente au premier domaine (2) semi-conducteur.

23. Dispositif suivant la revendication 22, dans lequel la première électrode (7) est couplée électriquement en outre à un domaine (3) semi-conducteur sur deux de façon à obtenir une durée de relaxation prescrite pour des charges emmagasinées dans le deuxième domaine (3) semi-conducteur.

24. Dispositif suivant l'une des revendications précédentes, dans lequel le courant de saturation de chaque dispositif (H1 à H5) a semi-conducteur représente au moins cinq fois le courant de limitation.
